(19) Europäisches Patentamt
European Patent Office
Office européen des brevets

(11) **EP 4 316 816 A1**

(12) **EUROPEAN PATENT APPLICATION**
published in accordance with Art. 153(4) EPC

(43) Date of publication:
**07.02.2024 Bulletin 2024/06**

(21) Application number: **22780370.7**

(22) Date of filing: **23.03.2022**

(51) International Patent Classification (IPC):
***B32B 27/00*** (2006.01) ***H01L 23/14*** (2006.01)
***H01L 21/02*** (2006.01) ***H01L 21/52*** (2006.01)

(52) Cooperative Patent Classification (CPC):
**B32B 27/00; H01L 21/02; H01L 21/52; H01L 23/14**

(86) International application number:
**PCT/JP2022/013454**

(87) International publication number:
**WO 2022/210155 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.04.2021 JP 2021062610**

(71) Applicant: **Toray Industries, Inc.**
**Tokyo 103-8666 (JP)**

(72) Inventors:
- **ARIMOTO, Yukari**
  **Otsu-shi, Shiga 520-8558 (JP)**
- **NAKAJIMA, Risano**
  **Otsu-shi, Shiga 520-8558 (JP)**
- **KOSHINO, Mika**
  **Otsu-shi, Shiga 520-8558 (JP)**
- **ARAKI, Hitoshi**
  **Otsu-shi, Shiga 520-8558 (JP)**
- **TOMIKAWA, Masao**
  **Otsu-shi, Shiga 520-8558 (JP)**
- **FUJIWARA, Takenori**
  **Otsu-shi, Shiga 520-8558 (JP)**
- **AOSHIMA, Kenta**
  **Otsu-shi, Shiga 520-8558 (JP)**

(74) Representative: **Hoefer & Partner Patentanwälte mbB**
**Pilgersheimer Straße 20**
**81543 München (DE)**

# (54) LAMINATE, RESIN COMPOSITION, AND METHOD FOR MANUFACTURING SEMICONDUCTOR DEVICE

(57) Provided is a laminate that allows semiconductor elements to be transferred over a wide range of processing margins using lasers of various wavelengths, without damaging the elements or leaving behind any pasty residue. This laminate is a substrate in which a laser-transmitting substrate 1, a resin film, and a semiconductor element are laminated in the stated order. The absorbance of the resin film at a wavelength of 248 nm, 266 nm, or 355 nm expressed in terms of a film thickness of 1.0 μm us 0.4-5.0, and the adhesive strength of the resin film with respect to the semiconductor elements is 0.02-0.3 N/cm.

Figure 2

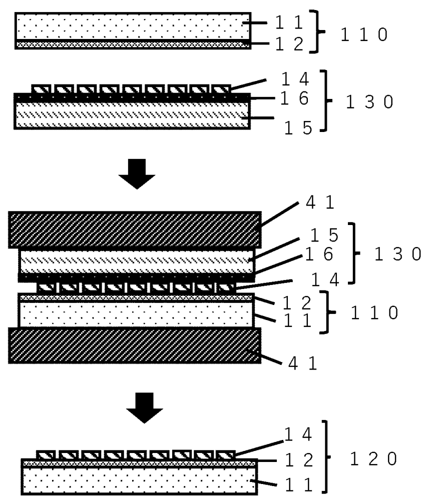


EP 4 316 816 A1

## Description

### TECHNICAL FIELD

The present invention relates to a laminate, a resin composition, and a production method for a semiconductor device. More specifically, it relates to a laminate that serves suitably in mounting semiconductor elements by the laser transfer technique and also relates to a semiconductor device production method that uses it.

### BACKGROUND ART

In general, elements to be incorporated in a semiconductor device are transferred and mounted on a circuit board or the like by the pick-and-place method using a tool such as flip chip bonder. In recent years, advanced and compact semiconductor devices have come in wider use. Accordingly, elements for use in them have also been miniaturized and slimmed down, and the number of these elements being installed in them has been increasing. Displays in which light-emitting diodes (LEDs), which are a type of semiconductor element, are arrayed as pixels have attracted attention recently because of their good features such as high brightness, low power consumption, and high image quality. The LEDs mounted in these pixels, which are called micro LEDs, are small type LEDs with sides of several hundred to several tens of micrometers. Manufacturing of micro LED displays by the above mounting method takes much time, and many investigations are now being made to develop new methods.

As a method for mounting a large number of small semiconductor elements, there is a technique that uses an adhesive stamp made of silicone resin or the like to mount chips from a wafer onto a circuit board (Patent documents 1 and 2). In this method, the adhesive stamp can hold more than one micro LED chip and serves to allow many chips to be placed on a circuit board in one pick-and-place process. In addition, another technique has been proposed in which chips are transferred from a wafer to a substrate designed for their transfer that has an adhesive layer and then transferred and mounted onto a circuit board or the like by the laser lift-off (LLO) technique (Patent documents 3, 4, and 5). This technique is advantageous because it serves to transfer chips with high speed and high positional accuracy.

### PRIOR ART DOCUMENTS

### PATENT DOCUMENTS

Patent document 1: Published Japanese Translation of PCT International Publication JP 2017- 531915
Patent document 2: Japanese Unexamined Patent Publication (Kokai) No. 2020-129638
Patent document 3: Japanese Unexamined Patent Publication (Kokai) No. 2020-188037
Patent document 4: Japanese Unexamined Patent Publication (Kokai) No. 2010-251359
Patent document 5: Published Japanese Translation of PCT International Publication JP 2014-515883

### SUMMARY OF INVENTION

### PROBLEMS TO BE SOLVED BY THE INVENTION

In the inventions described in Patent documents 1 and 2, the size of the stamp depends on the wafer size, and therefore, there is a limit to the number of semiconductor elements that can be transferred simultaneously. In addition, the inventions described in Patent documents 1 and 2 have problems such as the need to prepare a stamp that suites the design of the intended circuit board. On the other hand, although the LLO technique is free of area-related constraints and does not require the production of stamps of different designs, possibly serving to realize cost reduction, the inventions proposed in Patent documents 3 and 4, which include the removal of an adhesive layer by laser ablation, require the formation of a very thin adhesive layer and are likely to cause a reduction in yield due to a decrease in in-plane uniformity. Moreover, the inventions proposed in Patent documents 3 and 4 require the application of an excessive quantity of laser beam so that the adhesive layer is removed completely by ablation in order to prevent residues from being left on the surface of the semiconductor elements laid on the adhesive layer. This can cause problems such as contamination of the substrate with scattered material of the adhesive layer and damage due to destruction of semiconductor elements (hereinafter, such residue of the adhesive layer on the semiconductor element surface will be occasionally referred to as adhesive residue, and such scattered residue of the adhesive layer as debris). In the case of Patent document 5, the adhesive layer and the laser absorption layer are separated, and this allows transfer to be achieved with low energy and reduces damage to semiconductor elements. However, complicated steps are required to produce two layers and

the range of laser energy where transfer can be performed with high positional accuracy is narrow, resulting in a problem relating to the process margin required to realize transfer in a practical way.

## MEANS OF SOLVING THE PROBLEMS

To solve the above problems, the present invention provides a laminate including a substrate 1 with laser transparency and a resin film stacked in this order wherein the absorbance of the resin film converted to a film thickness of 1.0 μm is 0.4 or more and 5.0 or less at a wavelength in the range of 200 to 1,100 nm while the surface of the resin film opposite to the one in contact with the substrate 1 has an adhesive strength of 0.02 N/cm or more and 0.3 N/cm or less.

## ADVANTAGEOUS EFFECTS OF THE INVENTION

By means of the laminate according to the present invention, the transfer of semiconductor elements can be performed using laser beams of various wavelengths over a wide range of process margin without adhesive residue or damage to elements.

## BRIEF DESCRIPTION OF THE DRAWINGS

[Fig. 1] This is a diagram illustrating a method for producing a laminate 2. Hereinafter, a laminate in which semiconductor elements are laid will be occasionally referred to as a laminate 2.
[Fig. 2] This is a diagram illustrating a method for producing a laminate 2 using an adhesive for temporary bonding.
[Fig. 3] This is a diagram illustrating a method for producing a laminate 2 by the laser lift-off technique.
[Fig. 4] This is a diagram illustrating another method for producing a laminate 2 using a semiconductor substrate.
[Fig. 5] This is a diagram illustrating the step for disposing a laminate 2 in such a manner that the semiconductor element plane thereof faces a substrate 2 in carrying out a method for producing a semiconductor device.
[Fig. 6] This is a diagram illustrating the step for transferring a semiconductor element to a substrate 2 by applying a laser beam.

## DESCRIPTION OF PREFERRED EMBODIMENTS

The laminate according to the present invention is a laminate including a substrate 1 with laser transparency and a resin film stacked in this order wherein the absorbance of the resin film converted to a film thickness of 1.0 μm is 0.4 or more and 5.0 or less at a wavelength in the range of 200 to 1,100 nm and also wherein the surface of the resin film opposite to the one where the substrate 1 is in contact with the resin film has an adhesive strength of 0.02 N/cm or more and 0.3 N/cm or less. Hereinafter, a laminate having such a structure will be referred to as a laminate 1. The laminate 1 according to the present invention and the laminate 2 according to the present invention will be occasionally referred to simply as laminates according to the present invention.

Various components of the laminate 1 according to the present invention are described below.

The substrate 1 with laser transparency refers to a substrate having an absorbance of 0.1 or less at least somewhere in the wavelength range of 200 to 1,100 nm. Examples of substrates with such an absorbance include inorganic substrates such as quartz, sapphire, alkali glass, non-alkali glass, and borosilicate glass. The substrate may have any thickness as long as it does not impair the aforementioned absorbance, but it is preferably in the range of 0.1 mm to 5.0 mm. From the viewpoint of handling of the substrate, the thickness of the substrate is preferably 0.3 mm or more, and from the viewpoint of general availability, the thickness of the substrate is preferably 2.0 mm or less.

As the substrate 1 with laser transparency, it is also possible to use an organic substrate such as of PET, aramid, polyester, polypropylene, and cycloolefin. When an organic substrate is used, the substrate may have any thickness as long as it does not impair the aforementioned absorbance, but it is preferably in the range of 0.05 mm to 3.0 mm. From the viewpoint of handling of the substrate, the thickness of the substrate is preferably 0.1 mm or more, and from the viewpoint of the suppression of light scattering during laser beam irradiation, the thickness of the substrate is preferably 1.0 mm or less.

Next, the resin film is described below.

The resin film is one at least containing resin, and the absorbance of the resin film converted to a film thickness of 1.0 μm is 0.4 or more and 5.0 or less at a wavelength in the range from 200 to 1,100 nm. If this absorbance is 0.4 or more, it allows the applied laser beam to be absorbed intensively by the resin film when the laser beam is applied through the substrate 1 with laser transparency toward the resin film in order to transfer semiconductor elements to the opposite substrate. It is more preferable for the absorbance to be 0.6 or more because it allows the laser beam to be absorbed

particularly near the interface between the resin film and the substrate 1 with laser transparency, thereby facilitating chip transfer by a laser beam with even lower energy. Furthermore, from the viewpoint of material design, it is preferable for the absorbance to be 5.0 or less, and still more preferably 4.0 or less to allow the use of a general-purpose resin.

As for the resin to incorporate in the resin film, good examples include, but not limited to, resins that have absorption somewhere in the range of 200 to 1,100 nm, such as polyimide, polyimide precursor, polybenzoxazole, polybenzoxazole precursor, urethane resin, novolac resin, polyhydroxystyrene, polyester resin, acrylic resin, aramid resin, polysiloxane, and polyimide siloxane.

It is desirable for these resins to have conjugated structures in their structures. If these resins have conjugated structures, it serves to allow the converted absorbance at a film thickness of 1.0 μm measured at a wavelength between 200 and 1,100 nm to be in the range of 0.4 or more and 5.0 or less. Examples of structures having conjugated structures include aromatic ones and in particular, it is preferable for them to have such structures as biphenyl, imide, benzoxazole, and benzophenone. An absorbance as specified above can be achieved by adjusting the content of monomer residues with conjugated structures so that they account for 60 mol% or more of all monomer residues, which account for 100 mol%. The resin film may contain only one of these resins or may contain a plurality thereof.

An absorbance as specified above can be realized also by adding additives such as ultraviolet absorber, coloring matter, dyes, and pigments to the resin film. Examples of additives that can be contained in the resin film include ultraviolet absorbers such as Tinuvin PS, Tinuvin 99-2, Tinuvin 326, Tinuvin 328, Tinuvin 384-2, Tinuvin 400, Tinuvin 405, Tinuvin 460, Tinuvin 477, Tinuvin 479, Tinuvin 900, Tinuvin 928, and Tinuvin 1130 (all trade names, manufactured by BASF), DAINSORB T-0, DAINSORB T-7, DAINSORB T-31, DAINSORB T-52, DAINSORB T-53, DAINSORB T-84, DAINSORB P-6, and DAINSORB P-7 (all trade names, manufactured by Daiwa Kagaku); as well as coloring matters, dyes, and pigments such as Solvent Yellow 93, Solvent Yellow 33, Solvent Orange 60, Solvent Red 111, Solvent Red 135, Solvent Red 168, Solvent Red 207, Solvent Red 52, Solvent Red 179, Solvent Blue 36, Solvent Blue 94, Solvent Blue 63, Solvent Blue 104, Solvent Blue 97, Solvent Green 20, Solvent Violet1 3, and Solvent Violet 36 (all trade names, manufactured by Tokyo Chemical Industry Co., Ltd.), carbon black, perylene black, cyanine black, and aniline black.

The resin film may contain only one of these or may contain a plurality thereof. In regard to the amount of these additives required to control the absorbance in the aforementioned range, they preferably account for 0.1 part by weight or more relative to 100 parts by weight of the resin film, and from the viewpoint of its stability in the state of varnish prepared before forming a laminate, they preferably account for 50 parts by weight or less.

In regard to the resin film, the surface of the resin film opposite to the surface where the substrate 1 and the resin film are in contact with each other has an adhesive strength of 0.02 N/cm or more and 0.3 N/cm or less. The adhesive strength referred to herein means a value determined from 90°C peel test for peeling between the surface of the resin film and a Kapton film. A specific measurement method involves cutting out a 1 cm × 9 cm piece from a Kapton film, pressing it onto a resin film using a vacuum laminator under the conditions of 0.1 MPa and 25°C, and conducting a peeling test in which the pressure-bonded Kapton film is peeled off by pulling it at a constant speed of 2 mm/sec in the perpendicular direction to the resin film using a tensile testing machine.

If the adhesive strength is 0.02 N/cm or more, it serves to allow semiconductor elements laid on the resin film to be maintained stably. On the other hand, if the adhesive strength is 0.3 N/cm or less, it serves to allow the semiconductor elements to be transferred using a laser beam with a low energy density in the transfer step. The adhesive strength is more preferably 0.2 N/cm or less. If it is in this range, it serves to reduce the adhesive residue left on the semiconductor elements when the semiconductor elements are transferred by applying a laser beam through the substrate 1 with laser transparency.

In order to allow the resin film to have an adhesive strength in the range specified above, it is preferable for the resin film to contain a flexible component or a bent component. If a flexible component or a bent component is introduced, it acts to lower the glass transition temperature and increase the adhesive strength. Components that can work to increase the flexibility or bendability include those having flexible structures derived from aliphatic compounds, silane, etc., such as alkylene groups and siloxane, those having flexible structures derived from ether groups such as biphenyl ether, etc., and those having bent structures such as olefins. If monomer residues having these flexibility-developing structures account for 20 mol% or more of all monomer residues, which account for 100 mol%, present in the resins contained in the resin film, it allows the adhesive strength to be 0.02 N/cm or more. On the other hand, if they account for 70 mol% or less, it allows the adhesive strength to be 0.3 N/cm or less.

It is preferable for the resin film present in the laminate according to the present invention to contain a crosslinking agent. If it contains a crosslinking agent, part of the structure can be crosslinked to harden the surface of the resin film, thereby serving to adjust the adhesive strength. Furthermore, as the surface of resin film is strengthened as a result of crosslinking, it works more effectively to reduce the adhesive residue.

Examples of good crosslinking agents include compounds having alkoxymethyl groups or methylol groups such as DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DMLBisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all trade names, manufactured by Honshu Chemical Industry Co., Ltd.), and NIKALAC (registered trademark) MX-290, NIKALAC MX-280, NIKALAC MX-270, NIKALAC MX-279, NIKALAC MW-100LM, and NIKALAC MX-750LM (all trade names, manufactured by Sanwa Chemical Co., Ltd.).

Also, it preferably contains a crosslinking agent having an epoxy group. Good compounds having epoxy groups include, for example, bisphenol A type epoxy resin, bisphenol F type epoxy resin, propylene glycol diglycidyl ether, polypropylene glycol diglycidyl ether, polymethyl(glycidyloxypropyl) siloxane, other epoxy-containing silicones, and dimer acid modified epoxy resins, although the present invention is not limited thereto. More specifically, examples include Epicron 850-S, Epicron HP-4032, Epicron HP-7200, Epicron HP-820, Epicron HP-4700, Epicron EXA-4710, Epicron HP-4770, Epicron EXA-859CRP, Epicron EXA-1514, Epicron EXA-4880, Epicron EXA-4850-150, Epicron EXA-4850-1000, Epicron EXA-4816, and Epicron EXA-4822 (all trade names, manufactured by DIC Corporation), as well as Rikaresin BEO-60E (trade name, manufactured by New Japan Chemical Co., Ltd.), EP-4003S and EP-4000S (both trade names, manufactured byAdeka Corporation), JER871, JER872, YX-4000, and YX-4000H (all trade names, manufactured by Mitsubishi Chemical Corporation), CELLOXIDE 2021P (trade name, manufactured by Daicel Corporation), Shofree PETG, Shofree CDMGB, and Shofree BATG (all trade names, manufactured by Showa Denko K.K.), Denacol EX-201-IM (trade name, manufactured by Nagase ChemteX Corporation), and TEPIC-VL (trade name, manufactured by Nissan Chemical Industries).

It is also preferable to contain a crosslinking agent having an oxetanyl group, and specific examples thereof include OXT-121, OXT-221, OX-SQ-H, OXT-191, PNOX-1009, and RSOX (all trade names, manufactured by Toagosei Co., Ltd.), and Eternacoll (registered trademark) OXBP and Eternacoll OXTP (both trade names, manufactured by Ube Industries, Ltd.).

The resin film may contain two or more of these crosslinking agents. It can serve to reduce the amount of adhesive residue if it exists and preferably accounts for 1 part by weight or more relative to 100 parts by weight of the resin film. It more preferably accounts for 5 parts by weight or more relative to 100 parts by weight of the resin film because in that case, the amount of adhesive residue can be decreased more effectively. On the other hand, the crosslinking agent preferably accounts for 300 parts by weight or less relative to 100 parts by weight of the resin film. If its amount is in this range, the resin film will maintain a required flexibility, and accordingly, the resin film will be prevented from tearing during the transfer of semiconductor elements. From the viewpoint of storage stability in the state of varnish before use for forming a laminate, it is more preferably 200 parts by weight or less.

In particular, when the adhesive strength of the resin itself is more than 0.3 N/cm, the crosslinking agent preferably accounts for 5 parts by weight or more and 300 parts by weight or less relative to 100 parts by weight of the resin film. If the crosslinking agent contained accounts for 5 parts by weight or more, the adhesive strength of the resin, which is 0.3 N/cm or more, can be reduced to 0.3 N/cm or less. If it accounts for 300 parts by weight or less, the resin film can maintain a required flexibility. Furthermore, it preferably accounts for 10 parts by weight or more because it serves to reduce the amount of adhesive residue, whereas it preferably accounts for 200 parts by weight or less because it serves to improve the storage stability.

In addition, a curing accelerator may also be included in order to allow the crosslinking agent to work more effectively in promoting the curing reaction. Examples of such a curing accelerator include imidazoles, tertiary amines, salts thereof, and organic boron salts, of which imidazoles are preferable. Specific examples of imidazoles include imidazole, 2-methyl imidazole, 2-ethyl imidazole, 2-isopropyl imidazole, 2-n-propyl imidazole, 2-undecyl-1H-imidazole, 2-heptadecyl-1H-imidazole, 1,2-dimethyl imidazole, 2-ethyl-4-methyl imidazole, 2-phenyl-1H-imidazole, 4-methyl-2-phenyl-1H-imidazole, 2-phenyl-4-methyl imidazole, 1-benzyl-2-methyl imidazole, 1-cyanoethyl-2-methyl imidazole, 1-cyanoethyl-2-ethyl-4-methyl imidazole, 1-cyanoethyl-2-undecyl imidazole, 1-cyanoethyl-2-phenyl imidazole, 1-cyanoethyl-2-ethyl-4-methyl imidazolium trimellitate, 1-cyanoethyl-2-undecyl imidazolium trimellitate, 1-cyanoethyl-2-phenyl imidazolium trimellitate, 2,4-diamino-6-[2'-methyl imidazolyl-(1')]-ethyl-s-triazine, 2,4-diamino-6-[2'-undecylimidazolyl-(1')] -ethyl-s-triazine, 2,4-diamino-6-[2'-ethyl-4-methylimidazolyl-(1')]-ethyl-s-triazine, 2,4-diamino-6-[2'-methylimidazolyl-(1')]-ethyl-s-triazine isocyanuric acid addition product, 2-phenyl imidazole isocyanuric acid addition product, 2-methyl imidazole isocyanuric acid adduct, 2-phenyl-4,5-dihydroxymethyl imidazole, 2-phenyl-4-methyl-5-hydroxymethyl imidazole, 1-cyanoethyl-2-phenyl-4,5-di(2-cyanoethoxy)methyl imidazole, 1-dodecyl-2-methyl-3-benzyl imidazolium chloride, 1-benzyl-2-phenyl imidazole hydrochloride, and 1-benzyl-2-phenyl imidazolium trimellitate. Examples of commercially available products of preferable imidazoles include Curezol C17Z, Curezol 2MZ, Curezol 1B2MZ, Curezol 2E4MZ, Curezol 2E4MZ-CN, Curezol 2MZ-AZINE, and Curezol 2MZ-OK (all trade names, manufactured by Shikoku Chemicals Corporation).

In the resin film, the curing accelerator preferably accounts for 0.1 part by weight or more and 5.0 parts by weight or less relative to 100 parts by weight of the resin film. If its content is in this range, it will work sufficiently in accelerating the crosslinking reaction. Moreover, in order to maintain its stability in the state of varnish before use for forming a laminate, it is more preferable for the curing accelerator to account for 0.5 to 2.0 parts by weight in the resin film.

In addition, the resin film may further include a silane compound as needed. If a silane compound is included,

it can serve to adjust the adhesion between the resin film and the substrate 1 with laser transparency. This can prevent the resin film in the region not irradiated with the laser beam from being removed from the substrate 1 with laser transparency. Specific examples of such a silane compound include N-phenylaminoethyl trimethoxysilane, N-phenylaminoethyl triethoxysilane, N-phenylaminopropyl trimethoxysilane, N-phenylaminopropyl triethoxysilane, N-phenylaminobutyl trimethoxysilane, N-phenylaminobutyl triethoxysilane, vinyl trimethoxysilane, vinyl triethoxysilane, vinyl trichlorosilane, vinyl tris-(β-methoxyethoxy)silane, 3-methacryloxypropyl trimethoxysilane, 3-acryloxypropyl trimethoxysilane, p-styryl trimethoxysilane, 3-methacryloxypropylmethyl dimethoxysilane, and 3-methacryloxypropylmethyl diethoxysilane. In regard to the quantity of the silane compound, it preferably accounts for 0.01 part by weight or more and 15 parts by weight or less relative to 100 parts by weight of the resin film.

Furthermore, if necessary, the resin film may contain a surfactant for the purpose of improving the coating compatibility with the substrate 1 with laser transparency during film formation to allow the resulting resin film to have a uniform thickness.

The laminate according to the present invention includes a substrate 1 with laser transparency, a resin film, and semiconductor elements stacked in this order wherein the absorbance of the resin film converted to a film thickness of 1.0 μm is 0.4 or more and 5.0 or less at a wavelength in the range of 200 to 1,100 nm and also wherein the adhesive strength at the face where the semiconductor elements and the resin film are in contact with each other is 0.02 N/cm or more and 0.3 N/cm or less.

The features of the substrate 1 with laser transparency and the resin film in the laminate 2 are essentially the same as those for the laminate 1.

Described next are the semiconductor elements used for the present invention.

The semiconductor elements used for the present invention may be, for example, elements made of semiconductors such as GaN, AlN, InN, InP, GaAs, Si, and SiC. There are different types of semiconductor elements such as one containing other types of semiconductors stacked one on another and one containing an electrode material, sapphire substrate, glass substrate, wiring, etc., stacked one on another. In regard to the size of the semiconductor element, they preferably have sides of 5 μm or more and 5.0 mm or less. It is more preferable for them to have sides of 3.0 mm or less. In that case, the laser beam can be condensed and a smaller spot diameter can be realized to facilitate transfer with higher positional accuracy.

The number of semiconductor elements to be mounted on the laminate 2 according to the present invention is preferably $5/cm^2$ or more, and more preferably $50/cm^2$ or more. If the number of semiconductor elements is increased beyond this, it serves more effectively to allow the laser transfer process to realize a larger throughput. On the other hand, in order to irradiate each semiconductor element accurately with a laser beam, it is preferably $500,000/cm^2$ or less, and more preferably $100,000/cm^2$ or less.

As long as a substrate 1 with laser transparency, a resin film, and semiconductor elements are stacked in this order in the laminate 2 according to the present invention, another layer may be present between them. However, semiconductor elements should be formed directly on the resin film while the substrate 1 with laser transparency and the semiconductor elements should form the outermost surface layers of the laminate 2.

For the present invention, it is preferable for the resin film to show an absorbance as specified above at a wavelength selected from 248 nm, 266 nm, 308 nm, 355 nm, 532 nm, and 1,064 nm. It is still preferable for the resin film to show an absorbance as specified above at a wavelength selected from 248 nm, 266 nm, and 355 nm.

It is preferable that the absorbance of the resin film converted to a film thickness of 1.0 μm be 0.4 or more and 5.0 or less at a wavelength selected from 248 nm, 266 nm, 308 nm, 532 nm, and 1,064 nm and in addition, it is preferable that the absorbance of the resin film converted to a film thickness of 1.0 μm be 0.4 or more and 5.0 or less at a wavelength selected from 248 nm, 266 nm, and 355 nm. If the resin has an absorbance in the range specified above at any of these wavelengths, it facilitates efficient absorption of laser energy.

The resin film in the laminate according to the present invention preferably has a thickness of 0.7 μm or more and 30 μm or less. If it is 0.7 μm or more, the heat generated from the irradiation with a laser beam is prevented from being transmitted significantly to the semiconductor elements, and damage to the semiconductor elements can be suppressed. In addition, it serves to prevent the resin film from being broken and scattered as debris that can contaminate the opposite substrate.

On the other hand, if it is 30 μm or less, the deformation brought about by the ablation of the resin film that is caused by the application of a laser beam through the substrate 1 with laser transparency is transmitted efficiently to the interface with the semiconductor elements, and as a result, this allows the semiconductor elements to be transferred. It is more preferably 20 μm or less because it allows the semiconductor elements to be transferred to the opposite substrate with high positional accuracy.

The laminate according to the present invention preferably has an indentation hardness of 2 MPa or more and 500 MPa or less as measured by making an indentation in the direction from the resin film toward the substrate 1 with laser transparency. In the case of a laminate 2 that contains semiconductor elements, the semiconductor elements are removed first, and it is preferable for the laminate 2 deprived thereof to have an indentation hardness of 2 MPa or more

and 500 MPa or less as measured by making an indentation in the direction from the resin film toward the substrate 1.

The indentation hardness is a property that serves as an index when forming semiconductor elements on the resin film. If it is controlled in an appropriate range, it facilitates the formation of semiconductor elements on the resin film and serves to ensure an improved accuracy in the subsequent transfer of semiconductor elements by laser beam irradiation. The measurement of indentation hardness can be performed using a nanoindenter. In the case of a laminate 2, to enable hardness measurement, an appropriate number of semiconductor elements are physically removed from the laminate 2 to expose the resin surface to allow its measurement to be performed. Useful methods for removing semiconductor elements include one in which tweezers are used for direct removal of them and one in which a substrate, film, or other material that has large adhesive strength, such as dicing tape, is overlaid on the top surface of the semiconductor elements, followed by peeling it off. Measurements of indentation hardness are taken by carrying out an indentation loading/unloading test in a room-temperature, atmospheric pressure atmosphere. In the test, an indentation is made in the perpendicular direction from the surface of the resin film toward the substrate 1 with laser transparency using a Berkovich indenter (triangular pyramid diamond indenter), followed by removing the load. Here, measurements are taken at a measuring frequency of 100 Hz using the continuous rigidity measurement method. Based on the resulting load-indentation depth curve, the indentation hardness was calculated from values in the indentation region where the underlying substrate had no influence.

If the laminate deprived of semiconductor elements has an indentation hardness of 2 MPa or more, semiconductor elements will be prevented from being embedded into the resin film even if semiconductor elements are laid on the resin film by press-bonding the elements using a vacuum laminator or wafer bonder. Since the resin film does not adhere to the side faces of the semiconductor elements, their transfer can be performed using a laser with low energy. Furthermore, if the indentation hardness is 500 MPa or less, it allows semiconductor elements to be laid without suffering breakage of the semiconductor elements even if pressure is applied when laying the semiconductor elements. It is more preferable for the indentation hardness to be 300 MPa or less. If the indentation hardness is 300 MPa or less, it serves to ensure an improved yield in laying semiconductor elements on a resin film.

It is preferable for the resin film present in the laminate according to the present invention to have an elongation at break of 100% or more and 1,000% or less. If the elongation at break is 100% or more, the resin film will not be broken when it is irradiated with a laser beam. This can suppress the generation of debris from the resin film during the transferring step and prevent contamination of the opposite substrate. On the other hand, if the elongation at break is 1,000% or less, it prevents the laser-unirradiated areas of the resin film from being deformed under influence from the laser-irradiated areas of the resin film that are being deformed. The elongation at break is more preferably 200% or more and 800% or less. If it is controlled in this range, a laser beam to use for irradiation can be selected from a wide range of energy density, and as a result, it acts to improve the process margin.

A resin film can have an elongation at break of 100% or more and 1,000% or less when the resin present in the resin film has a structure with flexibility. Examples of such a structure with flexibility include alkylene structures, siloxane structures, and alkylene glycol structures. Specifically, this is realized by adding monomer residues with flexible structures in such a manner that these monomer residues account for 20 mol% or more of all monomer residues, which account for 100 mol%, that are present in the resin contained in the resin film. It is more preferable for the monomer residues with flexible structures to account for 30 mol% or more of all monomer residues, which account for 100 mol%, that are present in the resin.

For the laminate according to the present invention, it is preferable for the resin film to include one or more, as the resin (A), selected from the group consisting of a polyimide having a structure as represented by the formula (1), a polyimide precursor having a structure as represented by the formula (2), a polybenzoxazole having a structure as represented by the formula (3), a polybenzoxazole precursor having a structure as represented by the formula (4), and copolymers thereof.

[Chemical compound 1]

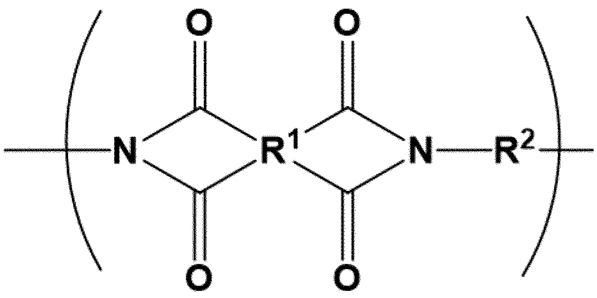

(1)

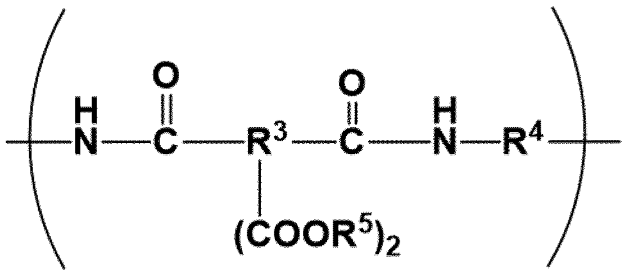

(2)

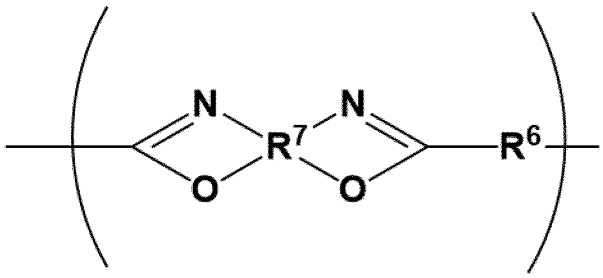

(3)

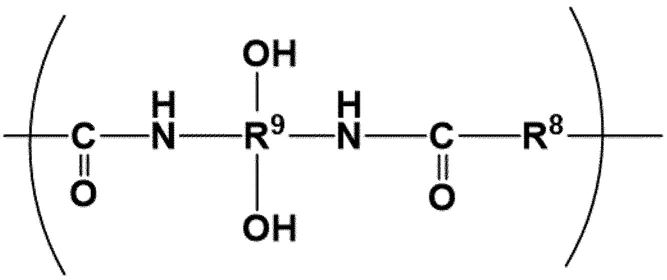

(4)

In the formulae (1) to (4), $R^1$, $R^3$, $R^7$, and $R^9$ each independently represent a tetravalent organic group having 6 to 40 carbon atoms, and $R^2$, $R^4$, $R^6$, and $R^8$ each independently represent a divalent organic group having 2 to 40 carbon atoms. $R^5$ represents a hydrogen atom or a monovalent organic group having 1 to 20 carbon atoms.

Polyimide and polybenzoxazole are resins having a cyclic structure, namely an imide ring or an oxazole ring, in their backbone chain structures. Furthermore, their precursors, namely, polyimide precursor and polybenzoxazole precursor, are resins that form an imide ring or a benzoxazole ring structure when dehydrated and cyclized. Each structure as represented by the formulae (1) to (4) serves as a repeating unit, and it is preferable for the resin to include 10 to 100,000 units thereof. If the number is in this range, it allows the resin film to be spread to an appropriate film thickness.

Polyimide can be produced by reacting a tetracarboxylic acid, or a corresponding substance such as tetracarboxylic dianhydride and tetracarboxylic acid diester dichloride, with a diamine, or a corresponding substance such as diisocyanate compound and trimethylsilylated diamine, and it contains a tetracarboxylic acid residue and a diamine

residue. For example, it can be produced by performing heat treatment to dehydrate and cyclize polyamic acid, which is a polyimide precursor and is formed by reacting a tetracarboxylic dianhydride and a diamine. During this heat treatment, a solvent, such as m-xylene, that forms an azeotropic mixture with water can also be added. As another method for its production, a dehydration condensation agent such as carboxylic anhydride and dicyclohexyl carbodiimide and a base such as triethyl amine that works as a cyclization catalyst may be added, followed by chemical heat treatment to cause dehydration and cyclization. As still another method, it can be produced by adding a weakly acidic carboxylic acid compound and performing heat treatment for dehydration and cyclization at a low temperature of 100°C or less.

Polybenzoxazole can be produced by reacting a bisaminophenol compound with a dicarboxylic acid or a corresponding substance such as dicarboxylic acid chloride and dicarboxylic acid active ester, and contains a dicarboxylic acid residue and a bisaminophenol residue. For example, it can be produced by subjecting polyhydroxyamide, which is a polybenzoxazole precursor and is formed by reacting a bisaminophenol compound and a dicarboxylic acid, to heat treatment to cause dehydration and cyclization. As another method, it can also be produced by adding a phosphoric anhydride, a base, a carbodiimide compound, etc., followed by chemical treatment to cause dehydration and cyclization.

In the formulae (1) and (2), $R^1$ and $R^3(COOR^5)$ each represent a tetracarboxylic acid residue. Examples of the tetracarboxylic acid residues that serve to form $R^1$ or $R^3(COOR^5)$ include residues of aromatic tetracarboxylic acids such as pyromellitic acid, 3,3',4,4'-biphenyltetracarboxylic acid, 2,3,3',4'-biphenyltetracarboxylic acid, 2,2',3,3'-biphenyltetracarboxylic acid, 3,3',4,4'-benzophenone tetracarboxylic acid, 2,2',3,3'-benzophenone tetracarboxylic acid, 2,2-bis(3,4-dicarboxyphenyl) hexafluoropropane, 2,2-bis(2,3-dicarboxyphenyl) hexafluoropropane, 1,1-bis(3,4-dicarboxyphenyl) ethane, 1,1-bis(2,3-dicarboxyphenyl) ethane, bis(3,4-dicarboxyphenyl) methane, bis(2,3-dicarboxyphenyl) methane, bis(3,4-dicarboxyphenyl) sulfone, bis(3,4-dicarboxyphenyl) ether, 1,2,5,6-naphthalene tetracarboxylic acid, 2,3,6,7-naphthalene tetracarboxylic acid, 2,3,5,6-pyridine tetracarboxylic acid, and 3,4,9,10-perylene tetracarboxylic acid; and residues of aliphatic tetracarboxylic acids such as butanetetracarboxylic acid and 1,2,3,4-cyclopentane tetracarboxylic acid. It may also be effective to use two or more of these tetracarboxylic acid residues in combination. The use of a tetracarboxylic acid residue that has an aromatic structure is preferable from the viewpoint of absorbance.

In the formulae (1) and (2), $R^2$ and $R^4$ each represent a diamine residue. Examples of the diamine residues that serve to form $R^2$ and $R^4$ include residues of diamines containing hydroxyl groups such as 2,2-bis(3-amino-4-hydroxyphenyl) hexafluoropropane, bis(3-amino-4-hydroxyphenyl) sulfone, 2,2-bis(3-amino-4-hydroxyphenyl) propane, bis(3-amino-4-hydroxyphenyl) methane, bis(3-amino-4-hydroxyphenyl) ether, 3,3'-diamino-4,4'-biphenol, and 9,9-bis(3-amino-4-hydroxyphenyl) fluorene; residues of diamines containing sulfonic acid groups such as 3-sulfonic acid-4,4'-diaminodiphenyl ether; residues of diamines containing thiol groups such as dimercaptophenylene diamine; residues of aromatic diamines such as 3,4'-diaminodiphenyl ether, 4,4'-diaminodiphenyl ether, 3,4'-diaminodiphenyl methane, 4,4'-diaminodiphenyl methane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy) benzene, benzidine, m-phenylene diamine, p-phenylene diamine, 1,5-naphthalene diamine, 2,6-naphthalene diamine, bis(4-aminophenoxyphenyl) sulfone, bis(3-aminophenoxyphenyl) sulfone, bis(4-aminophenoxy) biphenyl, bis{4-(4-aminophenoxy)phenyl} ether, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl; compounds produced by substituting part of the hydrogen atoms in aromatic rings in these substances with alkyl groups having 1 to 10 carbon atoms, fluoroalkyl groups, or halogen atoms; and residues of alicyclic diamines such as cyclohexyl diamine and methylenebiscyclohexyl amine. It may also be effective to include two or more of these diamine residues in combination. For the resin film, it is preferable from the viewpoint of absorbance that aromatic diamine residues account for 30 mol% or more of all diamine residues.

In the formula (2), $R^5$ represents a hydrogen atom or a monovalent organic group having 1 to 20 carbon atoms. Examples of the organic group having 1 to 20 carbon atoms include methyl group, ethyl group, propyl group, isopropyl group, butyl group, pentyl group, hexyl group, cyclohexyl group, octyl group, dodecyl group, and phenyl group. From the viewpoint of availability of raw materials for polymerization, the use of the methyl group or the ethyl group is preferable.

In the formulae (3) and (4), $R^6$ and $R^8$ each represent the residue of dicarboxylic acid, tricarboxylic acid or tetracarboxylic acid.

Examples of dicarboxylic acid residues include the residues of terephthalic acid, isophthalic acid, diphenyl ether dicarboxylic acid, bis(carboxyphenyl) hexafluoropropane, biphenyldicarboxylic acid, benzophenonedicarboxylic acid, and triphenyldicarboxylic acid, and examples of tricarboxylic acid residues include the residues of trimellitic acid, trimesic acid, diphenyl ether tricarboxylic acid, and biphenyltricarboxylic acid. Examples of tetracarboxylic acid residues are the same as those listed above for $R^1$ and $R^3$. Two or more of these may be used in combination.

In the formulae (3) and (4), $R^7$ and $R^9(OH)_2$ each represent a bisaminophenol derivative residue. Specific examples of such a bisaminophenol derivative residue include, but not limited to, the residues of 3,3'-diamino-4,4'-dihydroxybiphenyl, 4,4'-diamino-3,3'-dihydroxybiphenyl, bis(3-amino-4-hydroxyphenyl) propane, bis(4-amino-3-hydroxyphenyl) propane, bis(3-amino-4-hydroxyphenyl) sulfone, bis(4-amino-3-hydroxyphenyl) sulfone, 2,2-bis(3-amino-4-hydroxyphenyl)-1,1,1,3,3,3-hexafluoropropane, and 2,2-bis(4-amino-3-hydroxyphenyl)-1,1,1,3,3,3-hexafluoropropane,

and these compounds may be used either singly or as a combination of two or more thereof.

In addition, it is preferable to cap the chain end of the resins represented by the formulae (1) to (4) with a monoamine having an acid group, an anhydride, an acid chloride, or a monocarboxylic acid, because this can provide resins having acid groups at the ends of the backbone chains.

Preferable examples of such a monoamine include 2-aminophenol, 3-aminophenol, and 4-aminophenol. Two or more of these may be used in combination.

Preferable examples of such an anhydride, acid chloride, and monocarboxylic acid include generally known ones such as phthalic anhydride, maleic anhydride, and nadic anhydride. Di-tert-butyl dicarbonate is also preferably used as a reactive chain end. Two or more of these may be used in combination.

It is preferable for the resin (A) specified above to include one or more structures selected from the group consisting of a dimethylsiloxane structure as represented by the formula (5), a diphenylsiloxane structure as represented by the formula (6), an alkylene glycol structure as represented by the formula (7), and an alkylene structure as represented by the formula (8).

[Chemical compound 2]

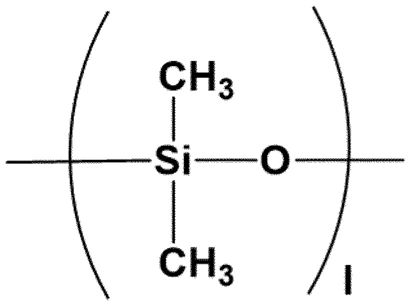

(5)

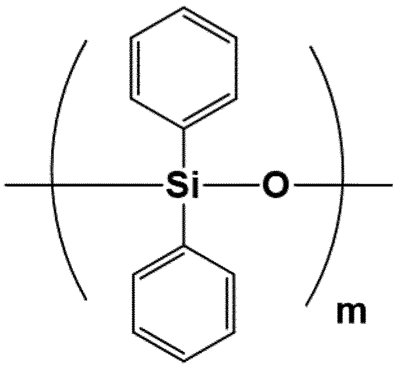

(6)

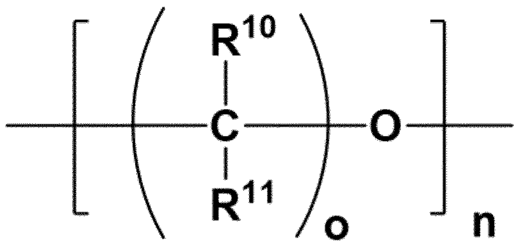

(7)

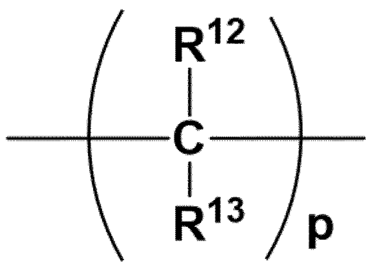

(8)

In the formulae (5) to (8), $R^{10}$ to $R^{13}$ each independently represent a hydrogen atom or a monovalent organic group having 1 to 20 carbon atoms. Here, l, m, and n each independently represent an integer of 4 to 40; p represents an integer of 10 to 40; and o represents an integer of 1 to 16.

If a structure as represented by any of the formulae (5) to (8) is included in the structure of the resin, this is preferable because it serves to improve the flexibility and adhesive strength of the resin film. $R^{10}$ to $R^{13}$ are as described in the explanation of $R^5$.

For aliphatic diamine residues, specific examples of such structures include diamine residues containing polyethylene oxide groups such as Jeffamine KH-511, Jeffamine ED-600, Jeffamine ED-900, Jeffamine ED-2003, Jeffamine EDR-148, and Jeffamine EDR-176, as well as D-200, D-400, D-2000, and D-4000, which are products of polyoxy propylene diamine (all trade names, manufactured by HUNTSMAN); and diamine residues containing polyalkylene oxide groups such as the residues of ELASMER 250P, ELASMER 650P, ELASMER 1000P, and Porea SL100A (all trade names, manufactured by Kumiai Chemical Industry Co., Ltd.). In addition, examples of siloxanediamine residues include the residues of propylamine-terminated siloxanediamines such as LP-7100, KF-8010, KF-8012, and X-22-161A (all trade names, manufactured by Shin-Etsu Chemical Co., Ltd.). Two or more of these diamine residues may be used in combination.

Furthermore, it is preferable for the resin (A) to be polyimide siloxane. Polyimide siloxane is a resin having a siloxane structure in the repeating structure of polyimide, and the polyimide siloxane to use for the present invention preferably contains a siloxanediamine residue as represented by the formula (9) in its structure.

[Chemical compound 3]

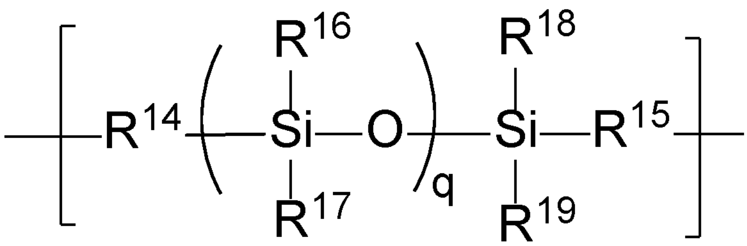

(9)

In the formula (9), q is a natural number of 1 to 50. $R^{14}$ and $R^{15}$ may be identical to or different from each other and they each represent an alkylene group containing 1 to 30 carbon atoms or a phenylene group. $R^{16}$ to $R^{19}$ may be identical to or different from each other and they each represent an alkyl group containing 1 to 30 carbon atoms, a phenyl group, or a phenoxy group.

Examples of siloxanediamine residues as represented by the formula (9) include those derived from diamines as listed below. More specifically, their examples include residues of α,ω-bis(3-aminopropyl)polydimethyl siloxane, α,ω-bis(3-aminopropyl)polydiethyl siloxane, α,ω-bis(3-aminopropyl)polydipropyl siloxane, α,ω-bis(3-aminopropyl)polydibutyl siloxane, α,ω-bis(3-aminopropyl)polydiphenoxy siloxane, α,ω-bis(2-aminoethyl)polydimethyl siloxane, α,ω-bis(2-aminoethyl)polydiphenoxy siloxane, α,ω-bis(4-aminobutyl)polydimethyl siloxane, α,ω-bis(4-aminobutyl)polydiphenoxy siloxane, α,ω-bis(5-aminopentyl)polydimethyl siloxane, α,ω-bis(5-aminopentyl)polydiphenoxy siloxane, α,ω-bis(4-aminophenyl)polydimethyl siloxane, and α,ω-bis(4-aminophenyl)polydiphenoxy siloxane. The siloxane diamines listed above may be contained singly or as a combination of two or more thereof. Polyimide siloxane is characterized by being high in adhesive strength and also high in absorbance attributable to polyimide and in particular, its absorbance at 355 nm etc. can be increased.

For the laminate according to the present invention, the resin film preferably has a 1% weight loss temperature of 300°C or more. Here, the 1% weight loss temperature of the resin film is determined by heating the resin film at 250°C for 30 minutes. Even if heat treatment of the resin film has already been finished, this can be determined from a specimen heat-treated at 250°C for 30 minutes. If the 1% weight loss temperature is 300°C or more, it means that the entire resin film can be prevented from being degraded due to heat generated by laser light irradiation, and this serves to avoid the generation of debris due to degradation of the resin film.

To ensure a 1% weight loss temperature of 300°C or more, it is preferable for the resin film to contain a component with high thermal stability. Specific examples of such components with high thermal stability include rigid components such as aromatic rings, siloxanes having relatively high thermal stability among other flexible structures, and combinations thereof. A 1% weight loss temperature of 300°C or more can be achieved by using a resin in which monomer residues with high thermal stability as mentioned above account for 50% or more of all monomer residues, which account for 100 mol%. From the viewpoint of versatility of polymers, it is preferable for the 1% weight loss temperature to be 600°C or less.

Next, described below is the resin composition according to the present invention.

The resin composition according to the present invention is a resin composition including a resin (B), an ultraviolet absorber and/or a coloring matter (C), and a solvent (D) wherein the resin (B) contains one or more selected from the group consisting of a polyimide having a structure as represented by the formula (1), a polyimide precursor having a structure as represented by the formula (2), a polybenzoxazole having a structure as represented by the formula (3), a polybenzoxazole precursor having a structure as represented by the formula (4), and copolymers thereof, and also wherein the polyimide having a structure as represented by the formula (1), the polyimide precursor having a structure as represented by the formula (2), the polybenzoxazole having a structure as represented by the formula (3), the

polybenzoxazole precursor having a structure as represented by the formula (4), and the copolymers thereof each has one or more structure selected from the group consisting of a dimethyl siloxane structure as represented by the formula (5), a diphenyl siloxane structure as represented by the formula (6), an alkylene glycol structure as represented by the formula (7), and an alkylene structure as represented by the formula (8).

[Chemical compound 4]

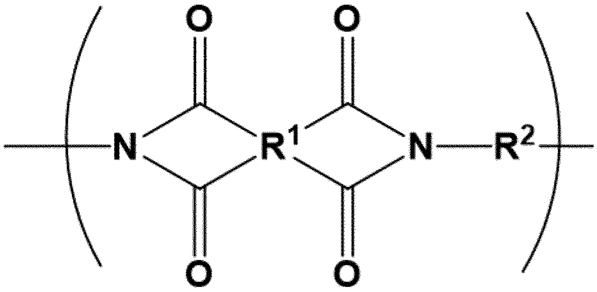

(1)

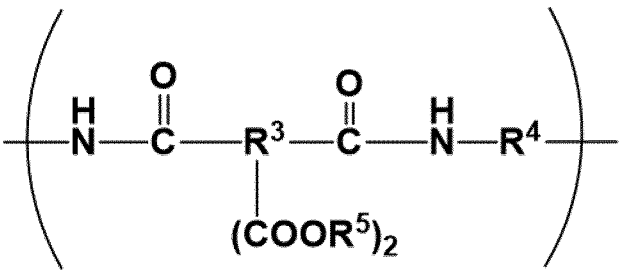

(2)

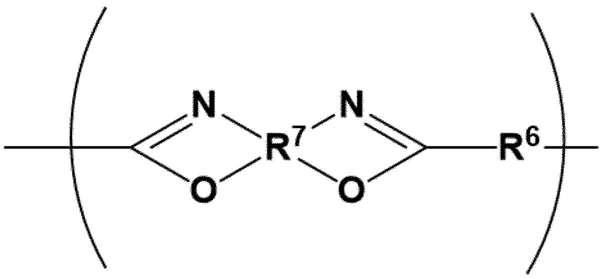

(3)

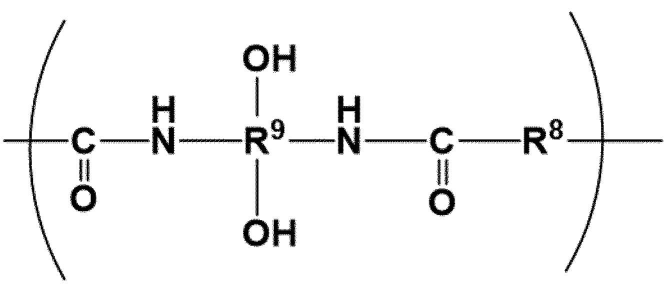

(4)

In the formulae (1) to (4), $R^1$, $R^3$, $R^7$, and $R^9$ each independently represent a tetravalent organic group having 6 to 40 carbon atoms, and $R^2$, $R^4$, $R^6$, and $R^8$ each independently represent a divalent organic group having 2 to 40

carbon atoms. $R^5$ represents a hydrogen atom or a monovalent organic group having 1 to 20 carbon atoms.

[Chemical compound 5]

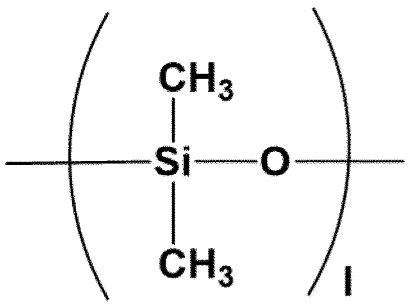

(5)

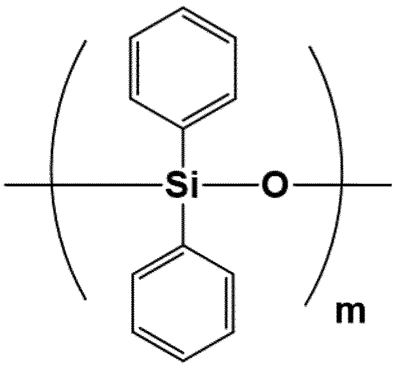

(6)

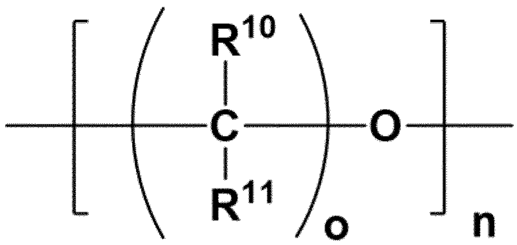

(7)

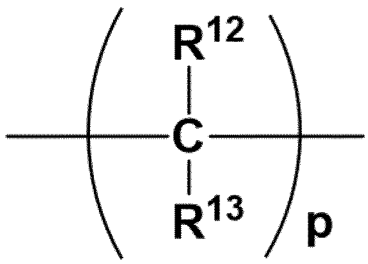

(8)

In the formulae (5) to (8), $R^{10}$ to $R^{13}$ each independently represent a hydrogen atom or a monovalent organic group having 1 to 20 carbon atoms. Here, l, m, and n each independently represent an integer of 4 to 40; p represents an integer of 10 to 40; and o represents an integer of 1 to 16.

The features of the formulae (1) to (8) for the resin (B) are essentially the same as those of the formulae (1) to (8) for the resin (A).

The resin (B) in the resin composition according to the present invention preferably contains polyimide siloxane. Polyimide siloxane is a resin having a siloxane structure in the repeating structure of polyimide, and in particular, the polyimide siloxane present in the resin (B) preferably contains a siloxanediamine residue as represented by the formula (9) in its structure.

[Chemical compound 6]

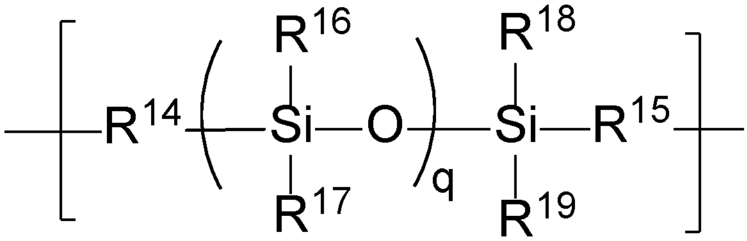

(9)

In the formula (9), q is a natural number of 1 to 50. $R^{14}$ and $R^{15}$ may be identical to or different from each other and they each represent an alkylene group containing 1 to 30 carbon atoms or a phenylene group. $R^{16}$ to $R^{19}$ may be identical to or different from each other and they each represent an alkyl group containing 1 to 30 carbon atoms, a phenyl group, or a phenoxy group.

The features of the formula (9) for the resin (B) are essentially the same as those of the formula (9) for the resin (A).

The resin composition according to the present invention contains a solvent (D), and preferable examples of the solvent (D) include, but not limited to, polar aprotic solvents such as N-methyl-2-pyrrolidone, γ-butyrolactone, N,N-dimethyl formamide, N,N-dimethyl acetamide, and dimethyl sulfoxide; ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether, ethylene glycol dibutyl ether, and dipropylene glycol dimethyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, 3-methoxy-3-methyl-1-butyl acetate, methyl lactate, ethyl lactate, and butyl lactate; ketones such as acetylacetone, methylpropyl ketone, methylbutyl ketone, methylisobutyl ketone, cyclopentanone, cyclohexanone, and 2-heptanone; alcohols such as butyl alcohol, isobutyl alcohol, pentanol, 4-methyl-2-pentanol, 3-methyl-2-butanol, 3-methyl-3-methoxybutanol, and diacetone alcohol; aromatic hydrocarbons such as toluene and xylene; and others such as dimethyl sulfoxide and γ-butyrolactone. These may be used singly or as a combination of two or more thereof.

The solvent (D) preferably accounts for 30 parts by weight to 3,000 parts by weight relative to 100 parts by weight of the resin (B), and it is desirable to adjust its concentration and viscosity in appropriate ranges where a resin film can be produced easily from the resin composition when performing a film production step.

The resin composition contains an ultraviolet absorber and/or a coloring matter (C). If an ultraviolet absorber and/or a coloring matter (C) is contained, that makes it easier to control the absorbance of the resin (B) and makes it possible to use laser beams of various wavelengths when transferring semiconductor elements.

Examples of the component (C) contained in the resin film include the same ultraviolet absorbers and coloring matters as listed above for the resin (A), and these can be contained singly or as a combination of two or more thereof.

In particular, it is preferable for the component (C) to contain one or more selected from the group consisting of benzotriazole based compounds, triazine based compounds, benzophenone based compounds, and benzoate based compounds. These compounds are so high in heat resistance that they serve to suppress the generation of debris during laser beam irradiation. In addition, because they absorb light in the wavelength range of 200 to 300-plus nm, they facilitate the transfer of semiconductor elements using a laser beam of a relatively short wavelength in the 200 to 300-plus nm range. The use of a laser beam of a wavelength in this range is preferable because the laser energy absorbed by the component (C) can also contribute to the decomposition of the resin (B) and accordingly serve to transfer semiconductor elements at a lower energy level.

In the resin composition according to the present invention, it is preferable that the component (C) account for 10 to 50 parts by weight relative to 100 parts by weight of the resin (B). If the component (C) accounts for 10 parts by weight or more relative to 100 parts by weight of the resin (B), it is possible to transfer semiconductor elements in a subsequent step designed for laser transfer of semiconductor elements even if the absorbance of the resin (B) itself is low. On the other hand, if the content of the component (C) is 50 parts by weight or less relative to 100 parts by weight of the resin (B), it serves to prevent the separation and precipitation of the component (C) in the resin composition. Furthermore, it is more preferable for the component (C) to be 30 parts by weight or less relative to 100 parts by weight

of the resin (B) because in that case, it will be possible to prevent the occurrence of foreign substances on the surface of the resin film while the resin composition is applied to form a resin film and avoid the precipitation of the component (C) onto the coat film surface during storage of the resin film.

The resin composition according to the present invention preferably further contains a crosslinking agent (E). When a resin film is produced, the inclusion of a crosslinking agent serves to form crosslinks in the surface of the resin film to make it strong. As a result, it acts to reduce the amount of adhesive residue formed from semiconductor elements when semiconductor elements are transferred by laser beam irradiation in a subsequent step. In addition, as the film strength is increased, the breakage of the resin film caused by laser beam irradiation can be prevented more strongly, leading to suppression of debris generation.

To give preferable examples of the crosslinking agent (E), the same crosslinking agents as listed above in the description of the resin (A) can also be used here as crosslinking agents. It is preferable for the crosslinking agent to be a compound having at least one group selected from the group consisting of epoxy group, oxetanyl group, alkoxymethyl group, and methylol group. If these crosslinking agents are used, it serves to provide a resin composition that maintains the ability to form a high-strength resin film without impairing the storage stability of the resin composition.

Two or more types of the crosslinking agent (E) may be contained in the resin composition. It is preferable for the crosslinking agent (E) to account for 0.5 to 30 parts by weight relative to 100 parts by weight of the resin (B). If the crosslinking agent (E) accounts for 0.5 part by weight or more relative to 100 parts by weight of the resin (B), the resin film formed from the resin composition will have crosslinks in the surface of the resin film, which serves to decrease the amount of adhesive residue generated on the semiconductor elements when the semiconductor elements are transferred by laser beam irradiation in a subsequent step. On the other hand, if it accounts for 30 parts by weight or less, the flexibility of the resin film formed from the resin composition is maintained and this serves to maintain the semiconductor elements easily.

The present invention provides a laminate including a substrate 1 with laser transparency, a resin film containing the aforementioned resin composition, and semiconductor elements stacked in this order. Since this laminate contains a layer of semiconductor elements, it can serve as a laminate for the undermentioned semiconductor device production, as in the case of the aforementioned laminate 2.

Next, the production method for a laminate according to the present invention is described below.

The laminate 1 can be produced by forming a resin film on a substrate 1 with laser transparency. A typical procedure of the production method for the laminate 1 is described below. A varnish prepared by dissolving the components for a resin film in a solvent is spread over a substrate 1 with laser transparency, and then it is heat-cured to produce a resin film. When producing the resin film by coating, any appropriate coating technique may be adopted, such as rotary coating using a spinner, spray coating, roll coating, and slit die coating. After coating, it is preferable to dry the resin film using a hot plate, a drying oven, infrared rays, etc., at a temperature of 50°C to 150°C for 1 minute to several tens of minutes. Then, if necessary, it is further heat-cured at a temperature of 100°C to 500°C for several minutes to several hours. Here, the resin film preferably has a thickness of 0.7 $\mu$m or more and 30 $\mu$m or less. The film thickness can be measured by a scanning electron microscope, optical film thickness measuring device, step profiler, etc.

Next, a typical procedure for laying semiconductor elements to produce a laminate 2 is described below with reference to diagrams.

Fig. 1 shows a procedure for forming a laminate 2 (120). First, a resin film (12) is laid on a substrate 1 (11) with laser transparency to prepare a laminate 1 (110), and then semiconductor elements (14) are arranged directly on the resin film (12), followed by performing press-bonding using a pressure device (41) such as vacuum laminator, wafer bonder, and press machine to provide a layered body. In another procedure that is illustrated in Fig. 2, semiconductor elements (14) are temporary bonded to a support body (15) with a temporary adhesive (16) to prepare a substrate (130) carrying temporary bonded semiconductor elements, and the semiconductor elements (14) on the temporary adhesive (16) are brought in contact with the surface of the resin film (12) in the laminate 1 (110), followed by press-bonding them using a pressure device (41) as described above. Subsequently, the temporary adhesive (16) and the support body (15) are removed from the semiconductor elements (13) to produce a laminate 2 (120). In another method, as illustrated in Fig. 3, semiconductor elements (14) are laid directly on a crystal growth substrate (17) such as sapphire to prepare a semiconductor element-carrying substrate (140), and the plane of the semiconductor elements (14) is brought into contact with the plane of the resin film (12), followed by press-bonding them using a pressure device (41) as described above. Then, a laser beam (31) is applied through the crystal growth substrate (17) so that the semiconductor elements (14) are transferred from the crystal growth substrate (17) to the laminate (110) by the laser lift-off mechanism. The optimum pressure used for laying the semiconductor elements depends on the adhesive strength of the resin film, and an appropriate value is set in the range of 0.05 MPa to 5.0 MPa. It is preferable to adopt a value of 2.0 MPa or less because it serves to avoid damage to the semiconductor elements and prevent them from being embedded into the resin film. Furthermore, when laying the semiconductor elements, they may be heated, as required, while applying a pressure. If they are heated, the flexibility of the resin film will increase to allow the semiconductor elements to be press-bonded at a lower pressure.

In addition, if alignment marks are made on the laminate in advance, they serve to facilitate transfer position adjustment in subsequent operations.

A still another method for producing a laminate 2 is explained below with reference to Fig. 4. On another support body (15), a semiconductor substrate (18) in an undiced state is bonded with a temporary adhesive (16). Furthermore, a varnish for resin film preparation is spread over the semiconductor substrate (18) in an undiced state and it is heat-cured. Immediately, the substrate 1 with laser transparency and the support body provided with a resin film are held so that they face each other, and then they are adhered. The support body (15) and the temporary adhesive (16) located next to the support body (15) are then peeled and removed, and then the semiconductor substrate (18) is diced into semiconductor elements (14) to produce a laminate 2 (120).

A similar procedure will be useful when a laminate corresponding to the laminate 2 is produced from a resin composition.

Described next is the production method for a semiconductor device.

The production method for a semiconductor device according to the present invention provides a process for producing a semiconductor device using the laminate 2 described above, and this semiconductor device production process includes a step for disposing the laminate 2 so that its semiconductor element plane faces a substrate 2 and a subsequent step for applying a laser beam through the substrate 1 with laser transparency present in the laminate 2 to transfer a semiconductor element to the substrate 2.

The step for disposing the laminate 2 so that its semiconductor element plane faces a substrate 2 is described below with reference to a diagram. Fig. 5 shows a procedure for producing a semiconductor device.

The semiconductor element plane refers to one of the surfaces of the laminate 2 (120) that has semiconductor elements (14).

The laminate 2 (120), which is produced by the method described above, and the substrate 2 (21) are disposed in such a manner that the surface of the laminate 2 (120) holding the semiconductor elements (14) faces the substrate 2 (21), wherein the laminate 2 (120) and the substrate 2 (21) are in parallel to each other. To prevent misalignment of semiconductor elements (14) due to their own weight during their transfer, the laminate 2 (120) and the substrate 2 (21) that face each other are disposed in such a manner that the laminate 2 (120) is on top. The laminate 2 and the substrate 2 are disposed at a certain distance apart. The distance between the semiconductor element plane and the substrate 2 can be set appropriately in the range of several micrometers to several hundred micrometers depending on the size and thickness of the semiconductor elements.

Any type of appropriate substrate can be used as the substrate 2, such as glass substrate, resin substrate, metal substrate, and circuit board with wiring formed thereon. Furthermore, an adhesive layer may be added to hold the transferred semiconductor elements. For the adhesive layer, an appropriate adhesive material can be adopted, including polysiloxane resin, acrylic resin, polyester resin, ACF resin, conductive silver paste, and the resin film used for the present invention. The adhesive layer may have a thickness in the range of 0.5 μm to 100 μm, and an appropriate value is adopted based on the size of the semiconductor elements and the distance between the semiconductor elements and the substrate 2.

In addition, alignment marks may also be made on the substrate 2 to help the alignment of transfer positions.

Next, the subsequent step for applying a laser beam through the substrate 1 with laser transparency in the laminate 2 to transfer a semiconductor element to the substrate 2 is described with reference to a diagram. In Fig. 6, the diagram 6a shows a typical step for chip transfer.

After preparing the laminate 2 (120) and the substrate 2 (21), which are arranged according to the procedure described above, a laser beam (31) is emitted from outside the substrate 1 (11) with laser transparency present in the laminate 2 (120) so that the beam travels through the substrate 1 (11) with laser transparency to irradiate a semiconductor element. Examples of useful laser beams include solid state lasers such as YAG laser, $YVO_4$ laser, fiber laser, and semiconductor laser, and gas lasers such as carbon dioxide laser, excimer laser, and argon laser, from which an appropriate one may be selected depending on the wavelength to be used. The beam profile to use for irradiation is not particularly limited, and the spot size of the laser beam may be smaller than the size of the semiconductor elements. However, it should not be so large that the laser beam can hit a semiconductor element located adjacent to the semiconductor element being transferred.

Furthermore, if the spot size of the laser beam is so large that it can hit an adjacent semiconductor element, it may be good to provide a photomask (41) and apply a laser beam (31) through it as shown in Fig. 6b. A laser beam of any appropriate energy density may be adopted. From the viewpoint of stability of the energy density of the laser beam in use, it is preferable to adopt a laser beam having an energy density of 1 $mJ/cm^2$ or more, and from the viewpoint of preventing damage to the semiconductor elements and shortening the processing time, its energy density is preferably 1,000 $mJ/cm^2$ or less. It is more preferable for the laser beam to have an energy density of 10 $mJ/cm^2$ or more and 500 $mJ/cm^2$ or less.

If the laminate 2 according to the present invention is used, it allows the transfer to be performed at a low energy, and even when the energy density of the laser beam is changed, its effects on positional accuracy and generation

of debris and adhesive residue will be small. There can be variations in the output energy density of the laser beam used for irradiation, and therefore, in order to minimize the impact of output variations on the transferring performance, it is preferable for the laminate 2 to show a constant transferring performance regardless of the energy density of the laser beam in use. It is preferable that a constant transferring performance be ensured over a laser beam energy density range of 30 $mJ/cm^2$ or more, and particularly preferably over a range of 50 $mJ/cm^2$ or more from the viewpoint of practical application.

Furthermore, the substrate 2 may be heated when transferring the semiconductor elements. Particularly in the case where the substrate 2 has an adhesive layer, it serves to hold the transferred semiconductor elements more strongly. In the case of heating the substrate 2, the temperature is preferably 100°C or less in order to prevent warping from being caused by heat from the substrate 2 to facilitate their transfer with high positional accuracy.

The step for transferring semiconductor elements is carried out while continuing positional adjustment to allow each semiconductor element to be disposed at the actual mounting position in the semiconductor device being produced. For example, when producing an LED substrate, LED elements are transferred while shifting the position at intervals depending on the pixel size of the LEDs and the arrangement of RGB colors. Then, the substrate 2 that carries transferred LED elements is placed so that it faces a circuit board, and they are press-bonded to the circuit board to produce a circuit board with LED elements mounted thereon. In the case where transfer is performed by means of the laminate according to the present invention, transfer can be achieved with high positional accuracy and accordingly, semiconductor elements can be transferred without misalignment from the circuit on the final board on which they are to be mounted, thereby reducing mounting failures attributable to positional misalignment.

It is preferable for the aforementioned laser beam to have a wavelength of 248 nm, 266 nm, 308 nm, 355 nm, 532 nm, or 1,064 nm, and in particular, it is preferable to adopt a wavelength at which the resin film shows an absorbance of 0.4 or more. The use of a laser beam as mentioned above serves to reduce damage to the semiconductor elements.

For the production method for a semiconductor device according to the present invention, it is more preferable for the aforementioned laser beam to have a wavelength of 248 nm, 266 nm, or 355 nm, which enables accurate transfer of very small semiconductor elements such as μLEDs. For laser beams of 248 nm, 266 nm, and 355 nm, it is particularly preferable to adopt an excimer laser or YAG laser.

Furthermore, when carrying out the production method for a semiconductor device according to the present invention, it is preferable for the substrate 2 to be a circuit board. If the substrate 2 is a circuit board, a substrate that carries transferred semiconductor elements can be converted directly into a semiconductor device. This eliminates the possibility of a positional misalignment caused by handling of the substrate after the chip transfer step, leading to an even higher positional accuracy. As such a circuit board, generally known ones such as TFT substrate and printed circuit board can be used.

The invention is described in more detail below with reference to examples.

## EXAMPLES

The present invention will be described below with reference to examples, though the present invention is not limited to these examples. First, the evaluation procedures used in the examples and comparative examples are described.

### (1) Preparation of laminate

A 4-inch glass substrate (manufactured by Corning Incorporated, Eagle XG, with an absorbance of 0.01 at 355 nm) having a thickness of 0.5 mm was coated, using a spinner, with a varnish for resin film formation that was prepared by the method described later, prebaked on a hot plate at 120°C for 3 minutes, and then heat-cured at an appropriate temperature for an appropriate time to produce a resin film on the glass substrate, thereby providing a laminate 1.

The film thickness of the resin film was determined by fracturing the laminate and observing the cross section under a scanning electron microscope (manufactured by Hitachi High-Technologies Corporation, S-4800).

Elsewhere, a silicon wafer with a thickness of 100 μm was prepared by polishing its rear surface, and the silicon wafer was affixed to a dicing tape (manufactured by Denka Company Limited, UDC-1025MC), followed by cutting it into a size of 100 μm × 200 μm with a dicing machine (manufactured by DISCO Corporation, DAD300) to produce dummy chips of semiconductor elements. The distance between the chips was 150 μm, and the number of the resulting dummy chips per unit area was 1,100 chips/$cm^2$.

A UV beam was applied to dicing tape to reduce its adhesiveness. One hundred dummy chips arrayed in a 10 × 10 grid were selected and the other ones surrounding them were removed with tweezers. The dummy chips adhered to the dicing tape were laid on the aforementioned laminate that consisted of a glass substrate and a resin film in such a manner that the resin film faces the chip plane. Then, the dummy chips were press-bonded to the resin film using a vacuum laminator. Subsequently, the dicing tape was peeled off to produce a laminate 2. The surfaces of the dummy

chips laid on the resin film were visually observed under an optical microscope to measure the number of chips laid on the resin film and the number of chips free of damage. Results are given in Tables 3 to 6.

(2) Measurement of absorbance of resin film

A varnish for resin film formation was spread on a quartz substrate in the same way as described in the section (1) above, prebaked, and heat-cured to produce a quartz substrate provided with a resin film for measuring absorbance. The film thickness was also measured. The absorbance was measured continuously over the range from 200 nm to 1,100 nm using an ultraviolet-visible spectrophotometer (manufactured by Hitachi Ltd., U-2910). From the measurements, values at 248 nm, 266 nm, 308 nm, 355 nm, 532 nm, and 1,064 nm were selected and the absorbance per micrometer was calculated for each of them according to the equation given below.

$$\text{Absorbance per } \mu m = \text{actual measured absorbance} / \text{measured film thickness } (\mu m)$$

(3) Measurement of adhesive strength of resin film

(3)-1 Measurement of adhesive strength of surface of resin film in laminate 1

A laminate 1 was produced by the method described above, and a Kapton film cut into a strip with a size of 1 cm × 9 cm was press-bonded to the surface of the resin film using a vacuum laminator under a pressure of 0.1 MPa at 25°C. A sample was set in a tensile tester (manufactured by NIDEC-SHIMPO Corporation, FGS-VC), and the press-bonded Kapton film was peeled vertically at a constant speed of 2 mm/sec. In this test, the peel strength was measured with a digital force gauge (manufactured by NIDEC-SHIMPO Corporation, FGJN-5). Three measurements were taken from different samples and the average was adopted to represent their adhesive strength.

(3)-2 Measurement of adhesive strength at the face where resin film in laminate 2 is in contact with semiconductor elements

A laminate 2 was produced by the method described above, and a piece of dicing tape (UDC-1025MC) was adhered to the faces of the dummy chips. Then, the dummy chips were removed by pulling the tape. A Kapton film was press-bonded in the same way as in the section (3)-1 to the surface of the resin film deprived of dummy chips, and then the adhesive strength was measured by the same technique as in the section (3)-1.

(4) Measurement of indentation hardness

The indentation hardness was measured using a nanoindenter (manufactured by Hysitron, Triboindenter TI950).

Dummy chips were removed from the laminate 2 by the same procedure as used for measuring the adhesive strength of the resin film in the section (3) above to provide a sample having an exposed resin film, which was then cut to a size of 10 mm × 10 mm.

The sample prepared was fixed to a dedicated sample mounting stage with an adhesive (manufactured by Toagosei Co., Ltd., Aron Alpha fast-acting versatile type), and measurement of the indentation hardness was performed according to indentation loading/unloading test in which an indentation was made from the surface of the resin film toward the glass substrate 1 using a Berkovich indenter (triangular pyramid diamond indenter) followed by removing the load. The measuring conditions were as described below.

[Measuring conditions]

Environment for measurement: 25±2°C, atmosphere
Measuring frequency: 100 Hz
Measuring method: continuous rigidity measurement method

Based on the resulting load-indentation depth curve, the indentation hardness was calculated from values in the indentation region where the underlying substrate had no influence.

(5) Measurement of film thickness

The thickness of the resin film was measured by fracturing the laminate 2 and observing the cross section under a scanning electron microscope (manufactured by Hitachi High-Technologies Corporation, S-4800).

(6) Measurement of elongation at break

Varnishes for resin films were spread on a piece of copper foil using a bar coater, prebaked on a hot plate at 120°C for 3 minutes, and then heat-cured at a specified temperature for a specified time period given in Table 2 described later to produce a resin film with a thickness of 10 μm on the copper foil. Then, the copper foil in the resulting copper foil based laminate containing the resin film was completely etched with a ferric chloride solution to produce a single layer of the resin film. The resulting single layer film was cut into a strip shape with a width of 1.5 cm and a length of 2 cm to provide a sample for elongation measurement. Using a Tensilon RTM-100 (manufactured by Orientec Co., Ltd.), measurement of elongation at break at room temperature of 23°C was performed by pulling a test piece at a tension speed of 50 mm/min in an atmosphere at room temperature of 23°C and a relative humidity of 45.0% RH. Ten strip-shaped test pieces were prepared from each sample. Then, the five largest values were selected from the test results and their average was calculated.

(7) Measurement of heat decomposition temperature

The single layer resin film used for the measurement of elongation at break was first heat-treated at 250°C for 30 minutes, and a specimen of about 15 mg was packed in an aluminum standard container and subjected to measurement using a thermogravimetric analyzer (manufactured by Shimadzu Corporation, TGA-50). In regard to the measuring conditions, the specimen was maintained at 120°C for 30 minutes and heated to 500°C at a heating rate of 5°C/min. From the resulting weight loss curve, the temperature at which the weight loss reached 1% was identified and this temperature was adopted as the 1% weight loss temperature.

(8) Semiconductor chip transfer test

(8)-1 Production of opposite substrate for chip transfer

Polydimethylsiloxane was diluted with toluene to prepare a diluted solution having a ratio by weight adjusted to 1:9 between polydimethylsiloxane and toluene and it was applied using a spinner over a 4-inch non-alkali glass substrate with a thickness of 0.5 mm (manufactured by Corning, EAGLE XG) that was provided with alignment marks and heat-cured on a hot plate at 120°C for 3 minutes to form an adhesive layer on the glass substrate. The thickness of the heat-cured adhesive layer was measured using an optical film thickness meter (manufactured by Dainippon Screen Mfg. Co., Ltd., Lambda Ace, refractive index 1.543), and an opposite substrate having an adhesive layer with a thickness of 20 μm was produced.

(8)-2 Transfer of semiconductor element

Next, a laser beam source, the laminate 2 produced by the method described above, and the opposite substrate were disposed in this order. Here, the surface of the laminate 2 carrying the dummy chips and the surface of the opposite substrate having the adhesive layer were held so that they faced each with a distance of 50 μm maintained between the surface of the dummy chips and the surface of the adhesive layer. The laminate 2 and the opposite substrate were aligned by means of their respective alignment marks. The spot size of the laser beam had a rectangular shape of 120 μm × 220 μm, and the positions of the laser beam source and the laminate were adjusted so that one dummy chip comes to the center of the laser beam spot while preventing the laser beam from hitting adjacent dummy chips.

A laser beam having a wavelength of 355 nm, 266 nm, 248 nm, 532 nm, or 1,064 nm was applied to the dummy chip located at the laser beam irradiation position, and laser beam irradiation was repeated with the energy density changed by 50 mJ/cm$^2$ each time over the range from 150 mJ/cm$^2$ to 400 mJ/cm$^2$. The transfer test was conducted for three dummy chips at each energy density.

(8)-3 Evaluation for transfer property

The opposite substrate was observed after the laser beam irradiation in order to determine how many of the three dummy chips had been transferred to the substrate 2. In addition, the dummy chips transferred to the opposite substrate were examined under a microscope and the sample was rated as "chip undamaged" if no chip was damaged

at any laser energy density or rated as "chip damaged" if any of the chips was found to be broken, chipped, or cracked.

(8)-4 Evaluation for positional accuracy

The position of the semiconductor elements on the opposite substrate after the transfer test was calculated from the alignment mark on the opposite substrate, and it was compared with the position of the laminate 2. Of the three chips subjected to transfer test at each laser beam energy density, the one suffering the largest positional misalignment was examined and the positional accuracy was evaluated as described below. The sample was rated as A for positional accuracy if the positional misalignment was less than $\pm 5$ μm in the X-axis direction and less than $\pm 5$ μm in the Y-axis direction, rated as C for positional accuracy if it was more than $\pm 10$ μm in the X-axis direction or more than $\pm 10$ μm in the Y-axis direction, or rated as B for positional accuracy if the misalignment was in between.

(8)-5 Evaluation for adhesive residue

After the laser beam irradiation, the transferred chips that were still in an unwashed state were observed. In the surfaces of the dummy chips that were in contact with the resin film, the area covered by adhesive residue from the resin film was determined. Relative to the area of the contact surface per chip with the resin film, which accounts for 100%, the average area covered by adhesive residue on the contact surface with the resin film was calculated for each chip that was transferred successfully at each energy density. Based on the results obtained, the sample was rated as A if the average area covered by adhesive residue accounted for 0% or more and less than 1%, rated as B if it accounted for 1% or more and less than 30%, and rated as C if it accounted for 30% or more.

(8)-6 Evaluation for debris

After the laser beam irradiation, the opposite substrate that was still in an unwashed state was observed to identify foreign objects of 1 μm or more existing around the transferred dummy chips on the adhesive layer surface. At each energy density, the average number of chips that were transferred successfully was calculated, and the sample was rated as A for debris if it was less than 10, rated as B for debris if it was 10 or more and less than 50, or rated as C for debris if it was 50 or more. If debris larger than 50 μm was contained, the sample was rated as C regardless of the number of debris objects.

(8)-7 Evaluation for process margin

Of the samples in which three dummy chips were transferred successfully to the substrate 2, those which were free of chip damage and were rated as A or B for positional accuracy in transfer, adhesive residue, and debris in the chip transfer test for the evaluations from (8)-3 to (8)-6 described above were considered to have good transfer properties at the relevant energy density, and they were examined to determine the energy density range over which chips were transferred successfully. A sample was rated as A for process margin if the energy range was 100 $mJ/cm^2$ or more, rated as B for process margin if it was 50 $mJ/cm^2$ or more and less than 100 $mJ/cm^2$, and rated as C for process margin if it was less than 50 $mJ/cm^2$.

(9) Method of measuring solid content in resin solution

From a resin solution prepared by the procedure described later, about 1 g was weighed in an aluminum cup, heated on a hot plate at 120°C for 3 minutes, then heated up to 250°C, and, after reaching 250°C, maintained there for 30 minutes. The weight of the resin remaining after heating was measured, and the solid content was calculated by the formula given below.

Solid content (wt%) = weight of resin after heating (g) / weight of resin solution before heating (g) x 100

The abbreviations used in the production examples given below refer to the following dianhydrides, diamines, additives, and solvents.

PMDA: pyromellitic dianhydride (manufactured by Daicel Corporation)
BPDA: 3,3',4,4'-biphenyltetracarboxylic dianhydride (manufactured by Mitsubishi Chemical Corporation)
BTDA: 3,3',4,4'-benzophenone tetracarboxylic dianhydride (manufactured by FUJIFILM Wako Pure Chemical Corporation)
DIBOC: di-tert-butyl dicarbonate (manufactured by Tokyo Chemical Industry Co., Ltd.)
PA: phthalic anhydride (manufactured by Tokyo Chemical Industry Co., Ltd.)
PDA: p-phenylene diamine (manufactured by Tokyo Chemical Industry Co., Ltd.)
BAHF: 4,4'-dihydroxy-3,3'-diaminophenyl hexafluoropropane (manufactured by Merck)
APPS2: $\alpha,\omega$-bis(3-aminopropyl)polydimethyl siloxane (average molecular weight 860, q=9 (average)) (manufactured by Shin-Etsu Chemical Co., Ltd.)
APPS3: $\alpha,\omega$-bis(3-aminopropyl)polydimethyl siloxane (average molecular weight 1,600, q=19 (average)) (manufactured by Shin-Etsu Chemical Co., Ltd.)
ELASMER 650P: polytetramethyleneoxide-di-p-aminobenzoate (molecular weight 888, manufactured by Kumiai Chemical Industry Co., Ltd.)
ELASMER 1000P: polytetramethyleneoxide-di-p-aminobenzoate (molecular weight 1,238, manufactured by Kumiai Chemical Industry Co., Ltd.)
NMP: 2-methyl-1-pyrrolidone (manufactured by Mitsubishi Chemical Corporation)
DMIB: N,N-dimethylisobutyl amide (manufactured by Mitsubishi Chemical Corporation) CHN: cyclohexanone (manufactured by Toyo Gosei Co., Ltd.)
PETG: pentaerythritol based backbone epoxy resin (manufactured by Showa Denko K.K.)
2E4MZ: 2-ethyl-4methyl imidazole (manufactured by Shikoku Chemicals Corporation)
Tinuvin 477: hydroxyphenyltriazine based ultraviolet absorber (manufactured by BASF)
100LM: crosslinking agent having alkoxymethyl group as represented by the structural formula given below (manufactured by Sanwa Chemical Co., Ltd.)

[Chemical compound 7]

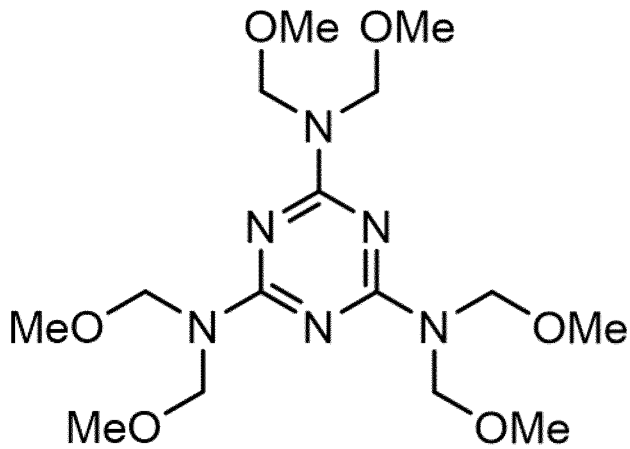

(10)

Production example 1 (polymerization of resin to include in resin film)

A reaction vessel equipped with a thermometer, a dry nitrogen inlet, a heating/cooling device using hot water/cooling water, and a stirring device was set up, and 11.79 g (0.109 mol) of PDA and 195.8 g of DMIB were fed together and dissolved. In this liquid, a mixed solution of 0.48 g (2.19 mmol) of DIBOC and 26.1 g of DMIB was dropped while stirring, and stirred at 40°C for 1 hour. Next, 12.87 g (0.437 mol) of BPDA and 13.05 g of DMIB were added and stirred at 60°C for 30 minutes. Then, 13.83 g (0.063 mol) of PMDA and 13.05 g of DMIB were added and stirred at 60°C for 4 hours to prepare a polyimide precursor PAA-1 solution with a 13 wt% solid content. In PAA-1, monomer residues having an aromatic ring structure account for 99.5 mol% of all monomer residues, which account for 100 mol%. PAA-1 is a resin having a structure as represented by the formula (2).

Production example 2 (polymerization of resin to include in resin film)

A reaction vessel equipped with a thermometer, a dry nitrogen inlet, a heating/cooling device using hot water/cooling water, and a stirring device was set up, and 27.80 g (0.033 mol) of APPS2 and 129.4 g of NMP were fed together at 40°C and dissolved. In this liquid, 8.25 g (0.076 mol) of PDA and 16.17 g of NMP were added and dissolved. Next, 15.87 g (0.054 mol) of BPDA and 17.39 g (0.054 mol) of BTDA were added along with 16.17 g of NMP. The mixture was reacted at 60°C for 4 hours to prepare a polyimide precursor PAA-2 solution with a 30 wt% solid content. In PAA-2, monomer residues having an aromatic ring structure account for 84.9 mol% of all monomer residues, which account for 100 mol%. PAA-2 is a resin having a structure as represented by the formula (2) and the formula (5).

Production example 3 (polymerization of resin to include in resin film)

A reaction vessel equipped with a thermometer, a dry nitrogen inlet, a heating/cooling device using hot water/cooling water, and a stirring device was set up, and 344.0 g (0.40 mol) of APPS2, 37.50 g (0.025 mol) of APPS3, and 27.47 g (0.075 mol) of BAHF were fed along with 481.4 g of CHN and dissolved, followed by adding 14.81 g (0.10 mol) of PA and 20.00 g of CHN and stirring at 60°C for 15 minutes. Then, 97.61 g (0.45 mol) of PMDA and 20.00 g of CHN were added, stirred at 60°C for 1 hour, heated up to 145°C, and allowed to react for 4 hours to prepare a polyimide siloxane PIS-1 solution with a 50 wt% solid content. PIS-1 is a resin having a structure as represented by the formula (1) and the formula (5).

Production example 4 (polymerization of resin to include in resin film)

A reaction vessel equipped with a thermometer, a dry nitrogen inlet, a heating/cooling device using hot water/cooling water, and a stirring device was set up, and 39.04 g (0.033 mol) of ELASMER 650P and 131.69 g of NMP were fed together at 40°C and dissolved. In this liquid, 8.25 g (0.076 mol) of PDA and 16.42 g of NMP were added and dissolved. Next, 15.87 g (0.054 mol) of BPDA and 17.39 g (0.054 mol) of BTDA were added along with 16.42 g of NMP. The mixture was reacted at 60°C for 4 hours to prepare a polyimide precursor PAA-3 solution with a 30 wt% solid content. In PAA-3, monomer residues having an aromatic ring structure account for 84.9 mol% of all monomer residues, which account for 100 mol%. PAA-3 is a resin having a structure as represented by the formula (2) and the formula (7).

Production example 5 (polymerization of resin to include in resin film)

A reaction vessel equipped with a thermometer, a dry nitrogen inlet, a heating/cooling device using hot water/cooling water, and a stirring device was set up, and 134.94 g (0.109 mol) of ELASMER 1000P and 353.23 g of NMP were fed together at 40°C and dissolved. Next, 15.87 g (0.054 mol) of BPDA and 17.39 g (0.054 mol) of BTDA were added along with 39.25 g of NMP. The mixture was reacted at 60°C for 4 hours to prepare a polyimide precursor PAA-4 solution with a 30 wt% solid content. In PAA-4, monomer residues having an aromatic ring structure account for 50.0 mol% of all monomer residues, which account for 100 mol%. PAA-4 is a resin having a structure as represented by the formula (2) and the formula (7).

Production example 6 (polymerization of resin to include in resin film)

A reaction vessel equipped with a thermometer, a dry nitrogen inlet, a heating/cooling device using hot water/cooling water, and a stirring device was set up, and 11.79 g (0.109 mol) of PDA and 204.1 g of DMIB were fed together and dissolved. In this liquid, a mixed solution of 1.90 g (8.72 mmol) of DIBOC and 27.2 g of DMIB was dropped while stirring, and stirred at 40°C for 1 hour. Next, 12.83 g (0.044 mol) of BPDA and 13.61 g of DMIB were added and stirred at 60°C for 30 minutes. Then, 14.15 g (0.065 mol) of PMDA and 13.61 g of DMIB were added and stirred at 60°C for 4 hours to prepare a polyimide precursor PAA-5 solution with a 13 wt% solid content. In PAA-5, monomer residues having an aromatic ring structure account for 96.3 mol% of all monomer residues, which account for 100 mol%. PAA-5 is a resin having a structure as represented by the formula (2).

Production example 7 (polymerization of resin to include in resin film)

A reaction vessel equipped with a thermometer, a dry nitrogen inlet, a heating/cooling device using hot water/cooling water, and a stirring device was set up, and 27.80 g (0.033 mol) of APPS2 and 128.1 g of NMP were fed together at 40°C and dissolved. In this liquid, 8.25 g (0.076 mol) of PDA and 16.01 g of NMP were added and dissolved. Next, 15.55 g (0.053 mol) of BPDA and 17.03 g (0.053 mol) of BTDA were added along with 16.01 g of NMP. The mixture was reacted at 60°C for 4 hours to prepare a polyimide precursor PAA-6 solution with a 30 wt% solid content. In PAA-6, monomer residues having an aromatic ring structure account for 84.5 mol% of all monomer residues, which account for 100 mol%. PAA-6 is a resin having a structure as represented by the formula (2) and the formula (5).

Production example 8 (Synthesis of acrylic polymer (P-1))

A copolymer of methyl methacrylate, a methacrylic acid, and styrene (weight ratio 30/40/30) was synthesized according to a method described in literature (Japanese Patent No. 3120476, Example 1), and 40 parts by weight of

glycidyl methacrylate was added, then reprecipitated with purified water, filtered, and dried to prepare an acrylic polymer (P-1) powder with an average molecular weight (Mw) of 40,000 and an acid value of 110 (mgKOH/g).

Production example 9 (Preparation of carbon black dispersion liquid)

In a tank, 400 g of carbon black (TPX1291, manufactured by CABOT), 187.5 g of a 40 wt% solution of propylene glycol monomethyl ether acetate of the acrylic polymer (P-1), 62.5 g of a polymer dispersing agent (BYK21116, manufactured by BYK-Chemie), and 890 g of propylene glycol monoethyl ether acetate were fed and stirred for 1 hour with a homomixer (manufactured by Tokushu Kika Kogyo Co., Ltd.) to provide a preliminary dispersion liquid. Then, the preliminary dispersion liquid was fed to an Ultra Apex Mill (manufactured by Kotobuki Industry Co., Ltd.) equipped with a centrifugal separator that was 70% filled with zirconia beads with a diameter of 0.10 mm (manufactured by Toray Industries, Inc.) and they were dispersed at a rotation speed of 8 m/s for 2 hours to provide a carbon black pigment dispersion liquid Bk-2 having a solid content of 25 wt% and a pigment/resin ratio (by weight) of 80/20.

Examples 1 to 24 and Comparative examples 1 and 2

Resin solutions prepared as described in Production examples 1 to 7 were mixed with the carbon black dispersion liquid prepared in Production example 9, additives, and solvents as specified in Tables 1 and 2 and stirred to produce varnishes for resin film formation. The varnishes were filtered through a 0.2 μm PTFE filter. Using these varnishes, laminates were produced according to the procedures described above. Details and various evaluation results of the resulting laminates are summarized in Tables 3 to 9.

[Table 1]

Table 1

| purpose | name of varnish | resin solution | | additive | | | | solvent |
|---|---|---|---|---|---|---|---|---|
| | | type weight | specific structure contained in resin | type weight | type weight | type weight | type weight | type weight |
| varnish for resin film formation | varnish 1 | PAA-1 3.85 g | Equation (2) | - | - | - | - | DMIB 6.15 g |
| | varnish 2 | PAA-2 500 g | Equation (2) Equation (5) | - | - | - | - | NMP 5.00 g |
| | varnish 3 | PIS-1 6.67 g | Equation (1) Equation (5) | - | - | - | Tinuvin 477 0.67 g | CHN 2.67 g |
| | varnish 4 | PIS-1 5.64 g | Equation (1) Equation (5) | PETG 0.56 g | 100LM 0.03 g | 2E4MZ 0.03 g | Tinuvin 477 0.56 g | CHN 3.18 g |
| | varnish 5 | PIS-1 2.82 g | Equation (1) Equation (5) | PETG 0.28 g | 100LM 0.01 g | 2E4MZ 0.01 g | Tinuvin 477 0.28 g | CHN 6.59 g |
| | varnish 6 | PAA-3 1.67 g | Equation (2) Equation (7) | - | - | - | - | NMP 8.33 g |
| | varnish 7 | PAA-4 6.67 g | Equation (2) Equation (7) | - | - | - | - | NMP 3.33 g |
| | varnish 8 | PAA-5 6.15 g | Equation (2) | - | - | - | - | DMIB 3.85 g |
| | varnish 9 | PAA-6 6.67 g | Equation (2) Equation (5) | - | - | - | - | NMP 3.33 g |
| | varnish 10 | PIS-1 6.67 g | Equation (1) Equation (5) | - | - | - | Bk-2 0.34 g | CHN 2.99 g |
| | varnish 11 | PAA-6 6.67 g | Equation (2) Equation (5) | - | 100LM 0.02 g | - | - | NMP 3.31 g |
| | varnish 12 | PAA-6 6.67 g | Equation (2) Equation (5) | - | 100LM 0.02 g | - | Tinuvin 477 0.10 g | NMP 3.03 g |
| | varnish 13 | PAA-2 500 g | Equation (2) Equation (5) | - | 100LM 0.15 g | - | Tinuvin 477 0.08 g | NMP 3.11 g |

[Table 2]

Table 2

| uses | name of varnish | resin solution | | additive | | | | solvent |
|---|---|---|---|---|---|---|---|---|
| | | type weight | specific structure contained in resin | type weight | type weight | type weight | type weight | type weight |
| varnish for resin film formation | varnish 14 | PAA-4 6.67 g | Equation (2) Equation (7) | - | - | - | Bk-2 0.34 g | NMP 3.33 g |
| | varnish 15 | PIS-1 6.67 g | Equation (1) Equation (5) | - | - | - | Tinuvin 477 0.17 g | CHN 3.16 g |
| | varnish 16 | PIS-1 6.67 g | Equation (1) Equation (5) | - | - | - | Tinuvin 477 1.83 g | CHN 1.49 g |
| | varnish 17 | PIS-1 6.67 g | Equation (1) Equation (5) | - | - | - | Tinuvin 477 150 g | CHN 1.82 g |
| | varnish 18 | PIS-1 5.64 g | Equation (1) Equation (5) | PETG 0.96 g | 100LM 0.03 g | 2E4MZ 0.03 g | Tinuvin 477 0.56 g | CHN 2.78 g |
| | varnish 19 | PIS-1 5.64 g | Equation (1) Equation (5) | PETG 0.68 g | 100LM 0.03 g | 2E4MZ 0.03 g | Tinuvin 477 0.56 g | CHN 3.06 g |
| | varnish 20 | PIS-1 5.64 g | Equation (1) Equation (5) | PETG 0.03 g | 100LM 0.03 g | 2E4MZ 0.03 g | Tinuvin 477 0.56 g | CHN 3.71 g |

[Table 3]

Table 3

| | item | unit | Example 1 | Example 2 | Example 3 | Example 4 | Example 5 | Example 6 |
|---|---|---|---|---|---|---|---|---|
| substrate 1 with laser transparency | type | - | non-alkali glass | non-alkali glass | quartz substrate | non-alkali glass | non-alkali glass | non-alkali glass |
| resin film | varnish | - | varnish 8 | varnish 3 | varnish 3 | varnish 10 | varnish 10 | varnish 8 |
| | resin film calcination conditions | °C/min | 180/10 | 220/10 | 220/10 | 220/10 | 220/10 | 180/10 |
| | absorbance/μm at 248 nm | - | 4.50 | 2.38 | 2.38 | 2.20 | 2.20 | 4.50 |
| | absorbance/μm at 266 nm | - | 4.79 | 2.66 | 2.66 | 0.77 | 0.77 | 4.79 |
| | absorbance/μm at 308 nm | | 309 | 0.56 | 0.56 | 0.56 | 0.56 | 3.09 |
| | absorbance/μm at 355 nm | - | 1.88 | 0.59 | 0.59 | 0.50 | 0.50 | 1.88 |
| | absorbance/μm at 532 nm | | 0.04 | 0.01 | 0.01 | 0.46 | 0.46 | 004 |
| | absorbance/μm at 1,064 nm | | 000 | 000 | 0.00 | 0.42 | 0.42 | 000 |
| | adhesive strength of surface of resin film in laminate 1 | N/cm | 0.02 | 0.26 | 0.26 | 0.26 | 0.26 | 0.02 |
| | adhesive strength of face between resin film and semiconductor element in laminate 2 | N/cm | 0.02 | 0.26 | 0.26 | 0.26 | 0.26 | 0.02 |
| | film thickness | μm | 0.50 | 33.0 | 33.0 | 33.0 | 33.0 | 1.0 |
| | indentation hardness | MPa | 525 | 1.6 | 1.6 | 1.6 | 1.6 | 525 |
| | elongation at break | % | 7 | 1100 | 1100 | 1050 | 1050 | 7 |
| | 1% weight loss temperature | °C | 290 | 280 | 280 | 285 | 285 | 290 |
| results of laying chips | number of chips laid successfully | number | 75 | 100 | 100 | 100 | 100 | 78 |
| | number of chips laid successfully without damage | number | 68 | 100 | 100 | 100 | 100 | 71 |

[Table 4]

[Table 4]

| | item | unit | Example 7 | Example 8 | Example 9 | Example 10 | Example 11 | Example 12 | Example 13 |
|---|---|---|---|---|---|---|---|---|---|
| substrate 1 with laser transparency | type | - | non-alkali glass | non-alkali glass | non-alkali glass | non-alkali glass | non-alkali glass | non-alkali glass | non-alkali glass |
| resin film | varnish | - | varnish 4 | varnish 5 | varnish 6 | varnish 6 | varnish 7 | varnish 9 | varnish 11 |
| | resin film calcination conditions | °C/min | 180/10 | 220/10 | 180/10 | 250/10 | 200/10 | 200/10 | 200/10 |
| | absorbance/μm at 248 nm | - | 2.38 | 2.38 | 2.45 | 2.52 | 2.31 | 2.44 | 2.44 |
| | absorbance/μm at 266 nm | - | 2.88 | 3.88 | 2.60 | 2.73 | 2.57 | 2.01 | 2.01 |
| | absorbance/μm at 308 nm | | 0.56 | 0.56 | 2.55 | 2.62 | 2.38 | 2.61 | 2.61 |
| | absorbance/μm at 355 nm | - | 0.61 | 0.61 | 0.77 | 0.90 | 0.45 | 1.64 | 1.64 |
| | absorbance/μm at 532 nm | | 0.01 | 0.01 | 0.00 | 0.00 | 0.00 | 0.00 | 000 |
| | absorbance/μm at 1,064 nm | | 000 | 000 | 0.00 | 0.00 | 0.00 | 0.00 | 000 |
| | adhesive strength of surface of resin film in laminate 1 | N/cm | 0.18 | 0.03 | 0.03 | 0.02 | 0.03 | 0.03 | 004 |
| | adhesive strength of face between resin film and semiconductor element in laminate 2 | N/cm | 0.18 | 0.03 | 0.03 | 0.02 | 0.03 | 0.03 | 0.04 |
| | film thickness | μm | 250 | 2.0 | 2.0 | 2.0 | 2.0 | 2.0 | 2.0 |
| | indentation hardness | MPa | 1.6 | 2.6 | 400 | 150 | 80 | 85 | 90 |
| | elongation at break | % | 1100 | 1200 | 80 | 120 | 700 | 110 | 105 |
| | 1% weight loss temperature | °C | 275 | 275 | 285 | 285 | 280 | 254 | 254 |
| results of laying chips | number of chips laid successfully | number | 100 | 97 | 85 | 80 | 90 | 97 | 97 |
| | number of chips laid successfully without damage | number | 100 | 97 | 85 | 80 | 90 | 97 | 97 |

[Table 5]

[Table 5]

| | item | unit | Example 14 | Example 15 | Example 16 | Example 17 | Example 18 | Example 19 | Example 20 |
|---|---|---|---|---|---|---|---|---|---|
| substrate 1 with laser transparency | type | - | non-alkali glass | non-alkali glass | non-alkali glass | quartz | non-alkali glass | non-alkali glass | non-alkali glass |
| resin film | varnish | - | varnish 12 | varnish 2 | varnish 13 | varnish 2 | varnish 14 | varnish 15 | varnish 16 |
| | resin film calcination conditions | °C/min | 200/10 | 250/10 | 250/10 | 250/10 | 200/10 | 220/10 | 220/10 |
| | absorbance/μm at 248 nm | - | 2.48 | 2.45 | 2.44 | 2.45 | 2.45 | 2.18 | 2.79 |
| | absorbance/μm at 266 nm | - | 2.40 | 2.09 | 2.01 | 2.09 | 2.73 | 2.33 | 2.93 |
| | absorbance/μm at 308 nm | | 2.78 | 2.63 | 2.61 | 2.63 | 2.79 | 0.44 | 0.95 |
| | absorbance/μm at 355 nm | - | 1.82 | 1.68 | 1.64 | 1.68 | 0.77 | 0.48 | 0.77 |
| | absorbance/μm at 532 nm | | 0.00 | 000 | 0.00 | 000 | 0.46 | 0.11 | 0.11 |
| | absorbance/μm at 1,064 nm | | 000 | 000 | 0.00 | 0.00 | 0.42 | 000 | 000 |
| | adhesive strength of surface of resin film in laminate 1 | N/cm | 0.04 | 0.02 | 0.03 | 0.02 | 0.02 | 0.26 | 0.26 |
| | adhesive strength of face between resin film and semiconductor element in laminate 2 | N/cm | 0.04 | 0.02 | 0.03 | 0.02 | 0.02 | 0.26 | 0.26 |
| | film thickness | μm | 2.0 | 2.0 | 2.0 | 2.0 | 2.0 | 33.0 | 33.0 |
| | indentation hardness | MPa | 90 | 100 | 110 | 100 | 80 | 1.3 | 1.3 |
| | elongation at break | % | 105 | 150 | 150 | 150 | 700 | 1100 | 1100 |
| | 1% weight loss temperature | °C | 250 | 360 | 355 | 360 | 270 | 285 | 265 |
| results of laying chips | number of chips laid successfully | number | 97 | 95 | 98 | 95 | 95 | 100 | 100 |
| | number of chips laid successfully without damage | number | 97 | 95 | 98 | 95 | 95 | 100 | 100 |

[Table 6]

[Table 6]

| | item | unit | Example 21 | Example 22 | Example 23 | Example 24 | Comparative example 1 | Comparative example 2 |
|---|---|---|---|---|---|---|---|---|
| substrate 1 with laser transparency | type | - | non-alkali glass | non-alkali glass | non-alkali glass | non-alkali glass | non-alkali glass | non-alkali glass |
| resin film | varnish | - | varnish 17 | varnish 18 | varnish 19 | varnish 20 | varnish 1 | varnish 3 |
| | resin film calcination conditions | °C/min | 220/10 | 220/10 | 220/10 | 220/10 | 200/10 | 180/10 |
| | absorbance/μm at 248 nm | - | 2.78 | 2.38 | 2.38 | 2.38 | 4.53 | 2.38 |
| | absorbance/μm at 266 nm | - | 2.88 | 2.66 | 2.66 | 2.66 | 4.79 | 2.66 |
| | absorbance/μm at 308 nm | | 0.89 | 0.56 | 0.56 | 0.56 | 309 | 0.56 |
| | absorbance/μm at 355 nm | - | 100 | 0.59 | 0.59 | 0.59 | 1.90 | 0.59 |
| | absorbance/μm at 532 nm | | 0.11 | 0.11 | 0.11 | 0.11 | 0.04 | 0.01 |
| | absorbance/μm at 1,064 nm | | 000 | 000 | 0.00 | 0.00 | 0.00 | 000 |
| | adhesive strength of surface of resin film in laminate 1 | N/cm | 0.26 | 0.02 | 0.03 | 0.08 | 0.01 | 0.35 |
| | adhesive strength of face between resin film and semiconductor element in laminate 2 | N/cm | 0.26 | 0.02 | 0.03 | 0.08 | 0.01 | 0.35 |
| | film thickness | μm | 33.0 | 33.0 | 33.0 | 33.0 | 0.50 | 33.0 |
| | indentation hardness | MPa | 1.3 | 5.5 | 4.0 | 2.1 | 550 | 1.0 |
| | elongation at break | % | 1100 | 700 | 800 | 1050 | 12 | 1200 |
| | 1% weight loss temperature | °C | 270 | 285 | 285 | 285 | 340 | 280 |
| results of laying chips | number of chips laid successfully | number | 100 | 87 | 93 | 99 | 0 | 99 |
| | number of chips laid successfully without damage | number | 100 | 87 | 93 | 99 | 0 | 99 |

[Table 7]

[Table 7]

| | | | | Example 1 | Example 2 | Example 3 | Example 4 | Example 5 | Example 6 | Example 7 | Example 8 | Example 9 |
|---|---|---|---|---|---|---|---|---|---|---|---|---|
| | wavelength of laser beam | | nm | 355 | 355 | 248 | 532 | 1,064 | 355 | 355 | 355 | 355 |
| | | 150 | number of transferred chips | 0 | 0 | 1 | 0 | 0 | 1 | 1 | 2 | 1 |
| | | | damage to chips | not evaluated | not evaluated | absent | not evaluated | not evaluated | absent | absent | absent | absent |
| | | | positional | | | C | | | B | B | B | B |
| | | | accuracy adhesive residue | | | C | | | C | C | C | B |
| | | | debris | | | B | | | B | B | B | B |
| | | 200 | number of transferred chips | 2 | 1 | 3 | 0 | 0 | 2 | 2 | 3 | 2 |
| | | | damage to chips | absent | absent | absent | | | absent | absent | absent | absent |
| | | | positional accuracy | B | B | B | | | B | B | A | B |
| | | | adhesive residue | B | B | B | not evaluated | not evaluated | B | B | B | B |
| | | | debris | B | B | B | | | B | B | B | B |

(continued)

| | | | | Example 1 | Example 2 | Example 3 | Example 4 | Example 5 | Example 6 | Example 7 | Example 8 | Example 9 |
|---|---|---|---|---|---|---|---|---|---|---|---|---|
| results of transferring chips | laser beam irradiation energy density mJ/cm$^2$ | 250 | number of transferred chips | 3 | 1 | 3 | 1 | 1 | 3 | 3 | 3 | 3 |
| | | | damage to chips | absent | absent | absent | absent | absent | absent | absent | absent | absent |
| | | | positional accuracy | B | B | B | C | C | B | B | A | B |
| | | | adhesive residue | B | B | B | B | B | B | B | B | B |
| | | | debris | B | B | B | A | A | B | B | B | B |
| | | 300 | number of transferred chips | 3 | 2 | 3 | 1 | 1 | 3 | 3 | 3 | 3 |
| | | | damage to chips | present | absent | present | absent | absent | absent | absent | absent | absent |
| | | | positional accuracy | B | C | B | C | B | B | B | A | B |
| | | | adhesive residue | B | B | B | B | B | B | B | B | B |
| | | | debris | C | C | C | B | B | C | B | B | B |

(continued)

| | | | | Example 1 | Example 2 | Example 3 | Example 4 | Example 5 | Example 6 | Example 7 | Example 8 | Example 9 |
|---|---|---|---|---|---|---|---|---|---|---|---|---|
| | | 350 | number of transferred chips | 3 | 3 | 3 | 2 | 1 | 3 | 3 | 3 | 3 |
| | | | damage to chips | present | present | present | absent | absent | absent | absent | absent | absent |
| | | | positional accuracy | B | B | B | B | B | B | B | A | B |
| | | | adhesive residue | B | B | B | B | B | B | B | B | B |
| | | | debris | C | C | C | B | B | C | C | B | B |
| | | 400 | number of transferred chips | 3 | 3 | 3 | 3 | 3 | 3 | 3 | 3 | 3 |
| | | | damage to chips | present | present | present | absent | absent | present | absent | absent | present |
| | | | positional accuracy | B | B | C | B | B | B | B | A | B |
| | | | adhesive residue | B | C | C | B | B | B | C | C | B |
| | | | debris | C | C | C | C | C | C | C | C | C |
| | process margin | mJ/cm$^2$ debris | | 200 to 250 | 200 to 250 | 200 to 250 | 300 to 350 | 300 to 350 | 200 to 250 | 200 to 300 | 200 to 350 | 150 to 350 |
| | | evaluation | | B | B | B | B | B | B | A | A | A |

[Table 8]

[Table 8]

| | | | Example 10 | Example 11 | Example 12 | Example 13 | Example 14 | Example 15 | Example 16 | Example 17 | Example 18 |
|---|---|---|---|---|---|---|---|---|---|---|---|
| wavelength of laser beam | | nm | 355 | 355 | 355 | 355 | 355 | 355 | 355 | 266 | 532 |
| | 150 | number of transferred chips | 1 | 3 | 3 | 3 | 3 | 3 | 3 | 3 | 0 |
| | | damage to chips | absent | absent | absent | absent | absent | absent | absent | absent | not evaluated |
| | | positional accuracy | B | B | A | A | A | A | A | A | |
| | | adhesive residue | B | B | A | A | A | A | A | A | |
| | | debris | B | B | A | A | A | A | A | A | |
| | 200 | number of transferred chips | 2 | 3 | 3 | 3 | 3 | 3 | 3 | 3 | 0 |
| | | damage to chips | absent | absent | absent | absent | absent | absent | absent | absent | not evaluated |
| | | positional accuracy | B | A | A | A | A | A | A | A | |
| | | adhesive residue | B | B | A | A | A | A | A | A | |
| | | debris | B | B | A | A | A | A | A | A | |

(continued)

| | | | | Example 10 | Example 11 | Example 12 | Example 13 | Example 14 | Example 15 | Example 16 | Example 17 | Example 18 |
|---|---|---|---|---|---|---|---|---|---|---|---|---|
| results of transferring chips | laser beam irradiation energy density mJ/cm$^2$ | 250 | number of transferred chips | 3 | 3 | 3 | 3 | 3 | 3 | 3 | 3 | 1 |
| | | | damage to chips | absent | absent | absent | absent | absent | absent | absent | absent | absent |
| | | | positional accuracy | B | A | A | A | A | A | A | A | C |
| | | | adhesive residue | B | B | A | A | A | A | A | A | B |
| | | | debris | B | B | A | A | A | A | A | A | A |
| | | 300 | number of transferred chips | 3 | 3 | 3 | 3 | 3 | 3 | 3 | 3 | 1 |
| | | | damage to chips | absent | absent | absent | absent | absent | absent | absent | absent | absent |
| | | | positional accuracy | B | A | A | A | A | A | A | A | B |
| | | | adhesive residue | B | B | A | A | A | A | A | A | B |
| | | | debris | B | B | A | A | A | A | A | A | B |

(continued)

| | | | | Example 10 | Example 11 | Example 12 | Example 13 | Example 14 | Example 15 | Example 16 | Example 17 | Example 18 |
|---|---|---|---|---|---|---|---|---|---|---|---|---|
| | | 350 | number of transferred chips | 3 | 3 | 3 | 3 | 3 | 3 | 3 | 3 | 2 |
| | | | damage to chips | absent | absent | absent | absent | absent | absent | absent | absent | absent |
| | | | positional accuracy | B | A | A | A | A | A | A | A | B |
| | | | adhesive residue | B | B | A | A | A | A | A | A | B |
| | | | debris | B | B | B | A | A | A | A | A | B |
| | | 400 | number of transferred chips | 3 | 3 | 3 | 3 | 3 | 3 | 3 | 3 | 3 |
| | | | damage to chips | absent | absent | absent | absent | absent | absent | absent | absent | present |
| | | | positional accuracy | A | A | A | A | A | A | A | A | B |
| | | | adhesive residue | A | B | A | A | A | A | A | A | B |
| | | | debris | A | B | B | B | B | A | A | B | C |
| | process margin | mJ/$cm^2$ | | 150 to 400 | 150 to 400 | 150 to 400 | 150 to 400 | 150 to 400 | 150 to 400 | 150 to 400 | 150 to 400 | 300 to 350 |
| | | evaluation | | A | A | A | A | A | A | A | A | C |

[Table 9]

[Table 9]

| | | | | Example 19 | Example 20 | Example 21 | Example 22 | Example 23 | Example 24 | Comparative example 1 | Comparative example 2 |
|---|---|---|---|---|---|---|---|---|---|---|---|
| | wavelength of laser beam | | nm | 355 | 355 | 355 | 355 | 355 | 355 | 355 | 355 |
| | | 150 | number of transferred chips | 0 | 3 | 3 | 3 | 3 | 3 | | 0 |
| | | | damage to chips | not evaluated | absent | absent | absent | absent | absent | | not transferable and not evaluated |
| | | | positional accuracy | | B | Δ | A | A | A | | |
| | | | adhesive residue | | B | Δ | A | A | A | | |
| | | | debris | | B | Δ | A | A | A | | |
| | | 200 | number of transferred chips | 1 | 3 | 3 | 3 | 3 | 3 | | 0 |
| | | | damage to chips | absent | absent | absent | absent | absent | absent | | not transferable and not evaluated |
| | | | positional accuracy | B | B | Δ | A | A | A | | |
| | | | adhesive residue | B | B | Δ | A | A | A | | |
| | | | debris | B | B | Δ | A | A | A | | |

(continued)

| | | | | Example 19 | Example 20 | Example 21 | Example 22 | Example 23 | Example 24 | Comparative example 1 | Comparative example 2 |
|---|---|---|---|---|---|---|---|---|---|---|---|
| results of transferring chips | laser beam irradiation energy density mJ/cm$^2$ | 250 | number of transferred chips | 1 | 3 | 3 | 3 | 3 | 3 | dummy chips not transferable to resin film and not evaluated | 0 |
| | | | damage to chips | A | absent | absent | absent | absent | absent | | not transferable and not evaluated |
| | | | positional accuracy | B | Δ | Δ | A | A | A | | |
| | | | adhesive residue | B | Δ | Δ | A | A | A | | |
| | | | debris | B | C | Δ | A | A | A | | |
| | | 300 | number of transferred chips | 1 | 3 | 3 | 2 | 3 | 3 | | 0 |
| | | | damage to chips | present | absent | absent | absent | absent | absent | | not transferable and not evaluated |
| | | | positional accuracy | C | C | C | A | A | A | | |
| | | | adhesive residue | B | B | B | A | A | A | | |
| | | | debris | B | C | C | A | A | A | | |

(continued)

| | | | | Example 19 | Example 20 | Example 21 | Example 22 | Example 23 | Example 24 | Comparative example 1 | Comparative example 2 |
|---|---|---|---|---|---|---|---|---|---|---|---|
| | | 350 | number of transferred chips | 2 | 3 | 3 | 3 | 3 | 3 | | 1 |
| | | | damage to chips | present | absent | absent | absent | absent | absent | | absent |
| | | | positional accuracy | B | B | Δ | A | A | A | | B |
| | | | adhesive residue | B | B | Δ | A | A | A | | C |
| | | | debris | C | C | × | B | A | A | | C |
| | | 400 | number of transferred chips | 3 | 3 | 3 | 3 | 3 | 3 | | 2 |
| | | | damage to chips | present | present | present | absent | absent | absent | | present |
| | | | positional accuracy | B | B | B | A | A | A | | B |
| | | | adhesive residue | C | C | C | A | A | A | | C |
| | | | debris | C | C | C | C | A | B | | C |
| | process margin | $mJ/cm^2$ | | 200 to 250 | 150 to 200 | 150 to 250 | 150 to 350 | 150 to 400 | 150 to 400 | not evaluated | < 50 |
| | | rating | | C | B | A | A | A | A | C | C |

EXPLANATION OF NUMERALS

11 substrate 1 with laser transparency
12 resin film
14 semiconductor element
15 support body
16 temporary adhesive
17 substrate for crystal growth
18 semiconductor substrate
21 substrate 2
31 laser
41 press-bonding device
51 photomask
110 laminate 1
120 laminate 2
130 substrate having temporary bonded semiconductor elements
140 substrate having semiconductor elements

## Claims

1. A laminate comprising a substrate 1 with laser transparency and a resin film stacked in this order wherein the absorbance of the resin film converted to a film thickness of 1.0 μm is 0.4 or more and 5.0 or less at a wavelength in the range of 200 to 1,100 nm and also wherein the surface of the resin film opposite to the one where the substrate 1 is in contact with the resin film has an adhesive strength of 0.02 N/cm or more and 0.3 N/cm or less.

2. A laminate comprising a substrate 1 with laser transparency, a resin film, and semiconductor elements stacked in this order wherein the absorbance of the resin film converted to a film thickness of 1.0 μm is 0.4 or more and 5.0 or less at a wavelength in the range of 200 to 1,100 nm and also wherein the adhesive strength at the face where the semiconductor elements and the resin film are in contact with each other is 0.02 N/cm or more and 0.3 N/cm or less.

3. A laminate as set forth in either claim 1 or 2 wherein the absorbance of the resin film converted to a film thickness of 1.0 μm is 0.4 or more and 5.0 or less at a wavelength selected from 248 nm, 266 nm, 308 nm, 532 nm, and 1,064 nm.

4. A laminate as set forth in any one of claims 1 to 3 wherein the absorbance of the resin film 1 converted to a film thickness of 1.0 μm is 0.4 or more and 5.0 or less at a wavelength selected from 248 nm, 266 nm, and 355 nm.

5. A laminate as set forth in any one of claims 1 to 4 wherein the resin film has a thickness of 0.7 μm or more and 30 μm or less.

6. A laminate as set forth in any one of claims 1 to 5 wherein the indentation hardness that is measured by making an indentation in the direction from the resin film toward the substrate 1 with laser transparency is 2 MPa or more and 500 MPa or less.

7. A laminate as set forth in any one of claims 1 to 6 wherein the resin film has an elongation at break of 100% or more and 1,000% or less.

8. A laminate as set forth in any one of claims 1 to 7 wherein the resin film comprises, as the resin (A), one or more selected from the group consisting of a polyimide having a structure as represented by the formula (1), a polyimide precursor having a structure as represented by the formula (2), a polybenzoxazole having a structure as represented by the formula (3), a polybenzoxazole precursor having a structure as represented by the formula (4), and copolymers thereof:

[Chemical compound 1]

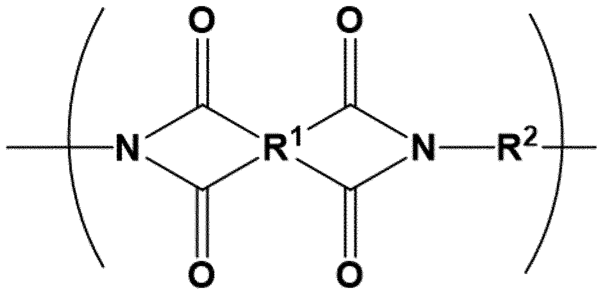

(1)

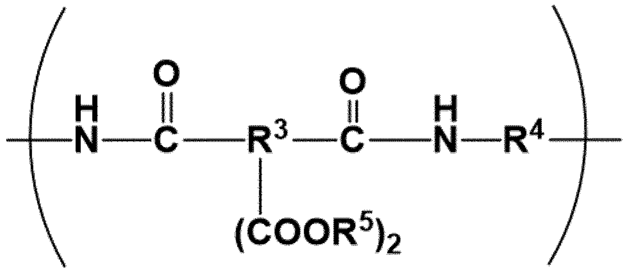

(2)

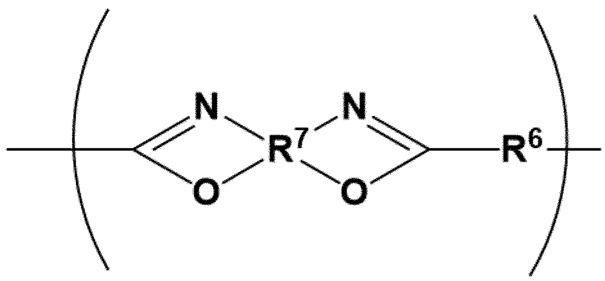

(3)

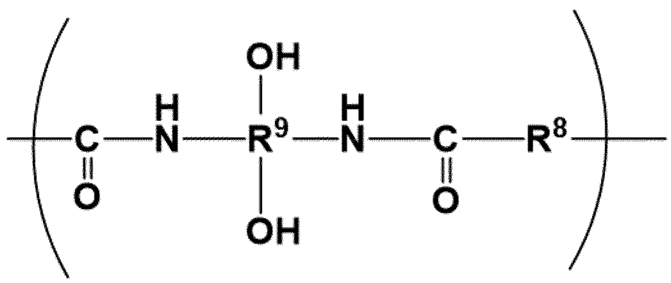

(4)

wherein in the formulae (1) to (4), $R^1$, $R^3$, $R^7$, and $R^9$ each independently represent a tetravalent organic group having 6 to 40 carbon atoms; $R^2$, $R^4$, $R^6$, and $R^8$ each independently represent a divalent organic group having 2 to 40 carbon atoms; and $R^5$ represents a hydrogen atom or a monovalent organic group having 1 to 20 carbon atoms.

**9.** A laminate as set forth in claim 8 wherein the resin (A) comprises one or more structures selected from the group consisting of a dimethylsiloxane structure as represented by the formula (5), a diphenylsiloxane structure as represented by the formula (6), an alkylene glycol structure as represented by the formula (7), and an alkylene structure as represented by the formula (8):

[Chemical compound 2]

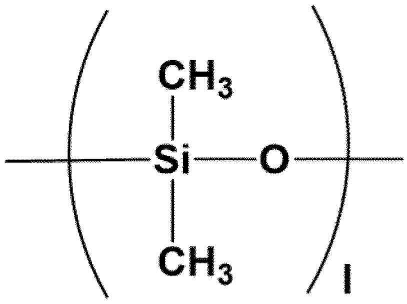

(5)

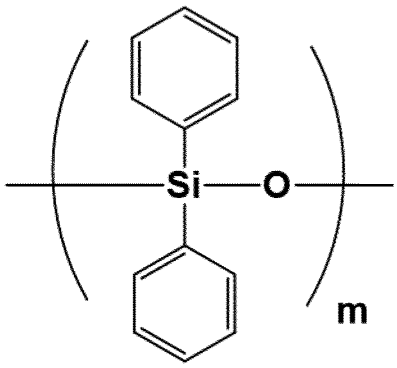

(6)

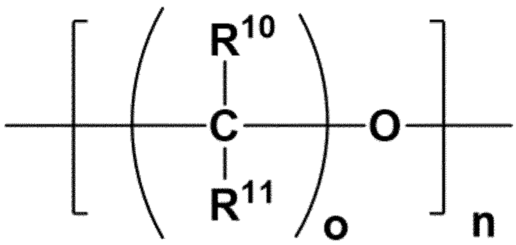

(7)

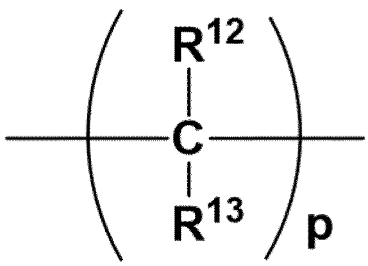

(8)

wherein in the formulae (5) to (8), $R^{10}$ to $R^{13}$ each independently represent a hydrogen atom or a monovalent organic group having 1 to 20 carbon atoms; l, m, and n each independently represent an integer of 4 to 40; p represents an integer of 10 to 40; and o represents an integer of 1 to 16.

**10.** A laminate as set forth in claim 9 wherein the resin (A) is polyimide siloxane.

**11.** A laminate as set forth in any one of claims 1 to 10 wherein the resin film contains a crosslinking agent.

**12.** A laminate as set forth in any one of claims 1 to 11 wherein the resin film contains an ultraviolet absorber agent and/or a coloring matter.

**13.** A laminate as set forth in any one of claims 1 to 12 wherein the resin film has a 1% weight loss temperature of 300°C or more.

**14.** A resin composition comprising a resin (B), an ultraviolet absorber and/or a coloring matter (C), and a solvent (D) wherein:

the resin (B) contains one or more selected from the group consisting of a polyimide having a structure as represented by the formula (1), a polyimide precursor having a structure as represented by the formula (2), a polybenzoxazole having a structure as represented by the formula (3), a polybenzoxazole precursor having a structure as represented by the formula (4), and copolymers thereof, and wherein the polyimide having a structure as represented by the formula (1), the polyimide precursor having a structure as represented by the formula (2), the polybenzoxazole having a structure as represented by the formula (3), the polybenzoxazole precursor having a structure as represented by the formula (4), and the copolymers thereof each has one or more structure selected from the group consisting of a dimethyl siloxane structure as represented by the formula (5), a diphenyl siloxane structure as represented by the formula (6), an alkylene glycol structure as represented by the formula (7), and an alkylene structure as represented by the formula (8):

[Chemical compound 3]

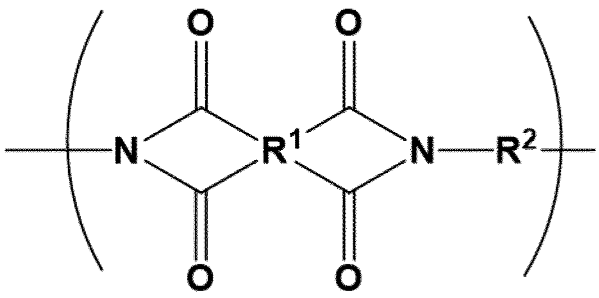

(1)

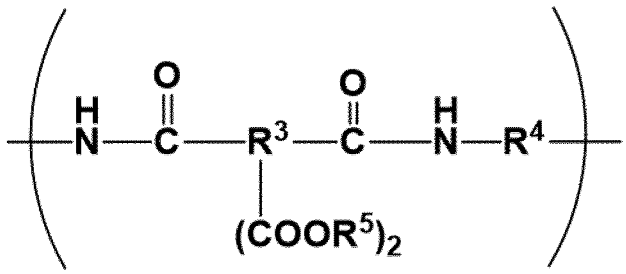

(2)

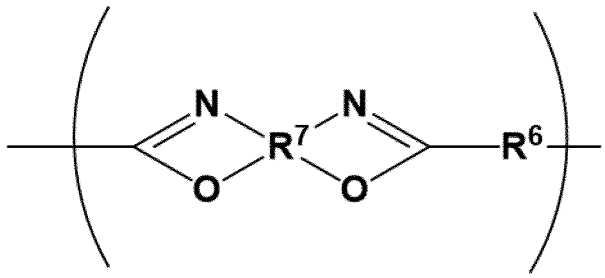

(3)

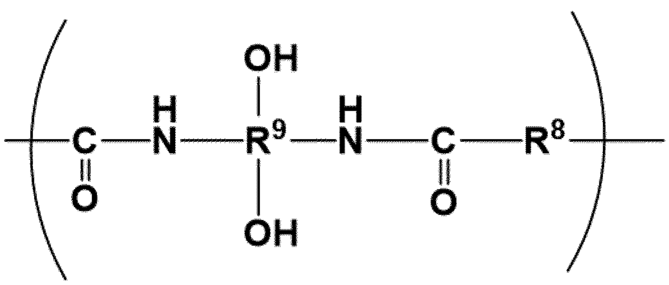

(4)

wherein in the formulae (1) to (4), $R^1$, $R^3$, $R^7$, and $R^9$ each independently represent a tetravalent organic group having 6 to 40 carbon atoms; $R^2$, $R^4$, $R^6$, and $R^8$ each independently represent a divalent organic group having 2 to 40 carbon atoms; and $R^5$ represents a hydrogen atom or a monovalent organic group having 1 to 20 carbon atoms:

[Chemical compound 4]

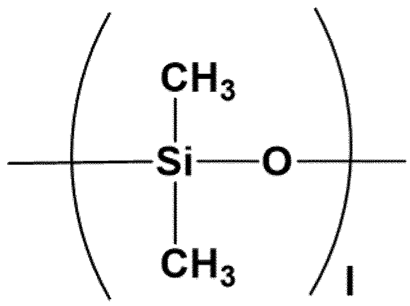

(5)

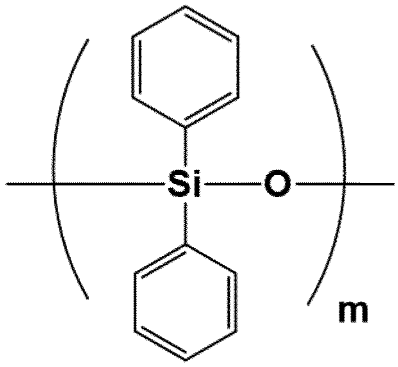

(6)

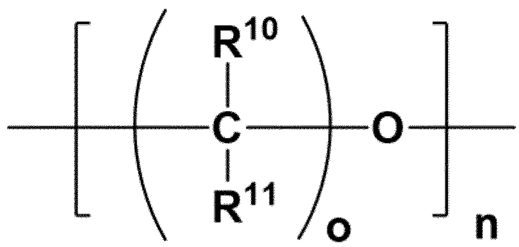

(7)

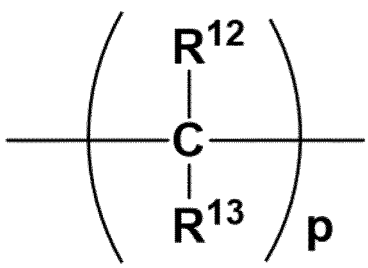

(8)

wherein in the formulae (5) to (8), $R^{10}$ to $R^{13}$ each independently represent a hydrogen atom or a monovalent organic group having 1 to 20 carbon atoms; l, m, and n each independently represent an integer of 4 to 40; p represents an integer of 10 to 40; and o represents an integer of 1 to 16.

**15.** A resin composition as set forth in claim 14 wherein the resin (B) is polyimide siloxane.

**16.** A resin composition as set forth in either claim 14 or 15 wherein the component (C) contains one or more selected from the group consisting of benzotriazole based compounds, triazine based compounds, benzophenone based

compounds, and benzoate based compounds.

**17.** A resin composition as set forth in any one of claims 14 to 16 wherein the component (C) accounts for 10 to 50 parts by weight relative to 100 parts by weight of the resin (B).

**18.** A resin composition as set forth in any one of claims 14 to 17 further comprising a crosslinking agent (E).

**19.** A resin composition as set forth in claim 18 wherein the crosslinking agent (E) is a compound having at least one group selected from the group consisting of epoxy group, oxetanyl group, alkoxymethyl group, and methylol group.

**20.** A resin composition as set forth in either claim 18 or 19 wherein the crosslinking agent (E) accounts for 0.5 to 30 parts by weight relative to 100 parts by weight of the resin (B).

**21.** A laminate comprising a substrate 1 with laser transparency, a resin film containing a resin composition as set forth in any one of the claims 14 to 20, and semiconductor elements stacked in this order.

**22.** A production method for a semiconductor device using a laminate as set forth in either claim 2 or 21 and comprising a step for disposing the laminate so that its semiconductor element plane faces the substrate 2 and a subsequent step for applying a laser beam through the substrate 1 with laser transparency present in the laminate to transfer a semiconductor element to the substrate 2.

**23.** A production method for a semiconductor device as set forth in claim 22 wherein the laser beam has a wavelength selected from 248 nm, 266 nm, and 355 nm.

**24.** A production method for a semiconductor device as set forth in either claim 22 or 23 wherein the substrate 2 is a circuit board.

Figure 1

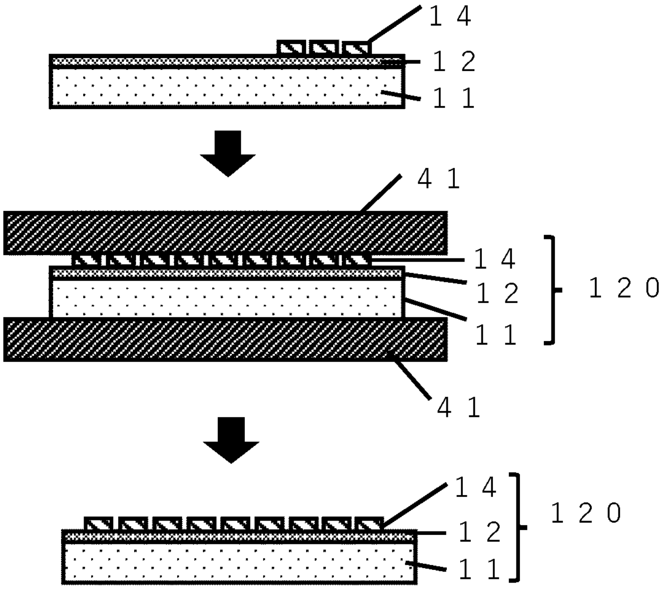


Figure 2

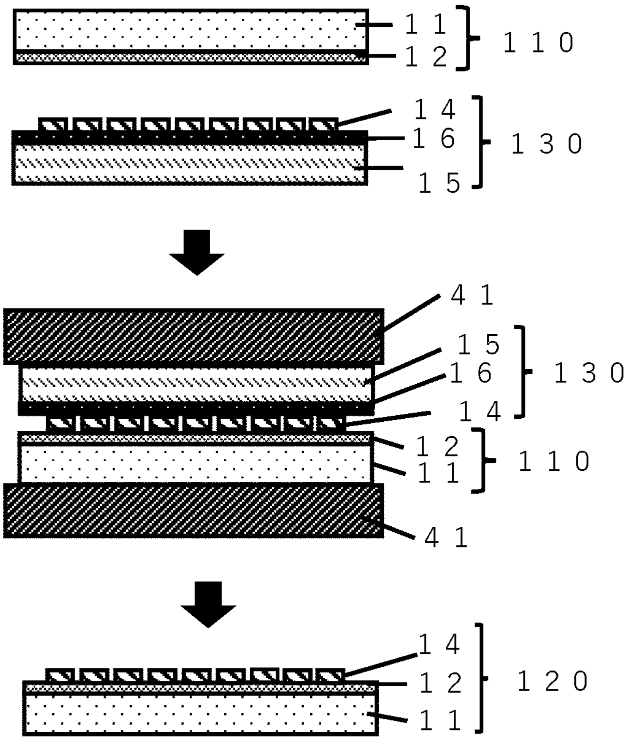

Figure 3

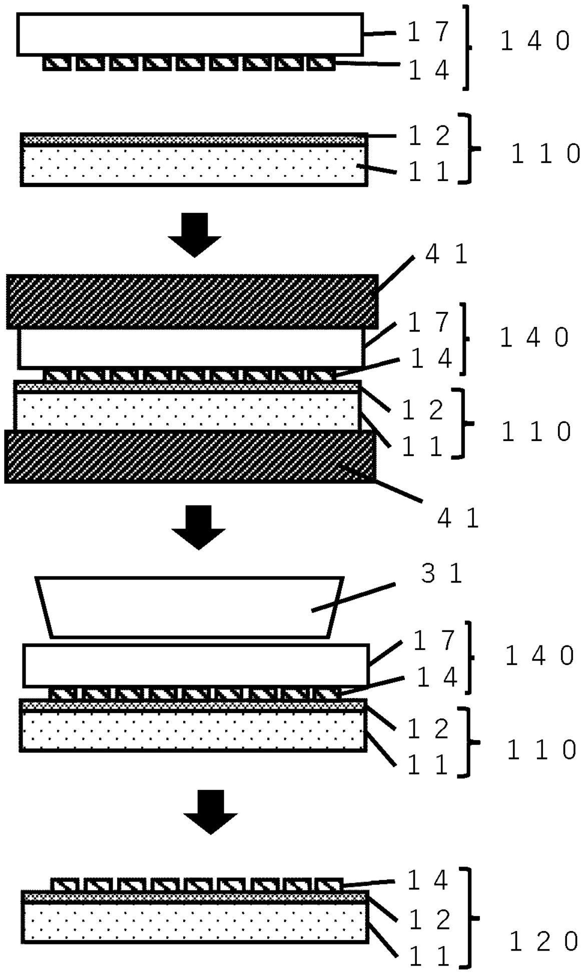
1 7
1 4
1 4 0
1 2
1 1
1 1 0
4 1
1 7
1 4
1 4 0
1 2
1 1
1 1 0
4 1
3 1
1 7
1 4
1 4 0
1 2
1 1
1 1 0
1 4
1 2
1 1
1 2 0

59

Figure 4

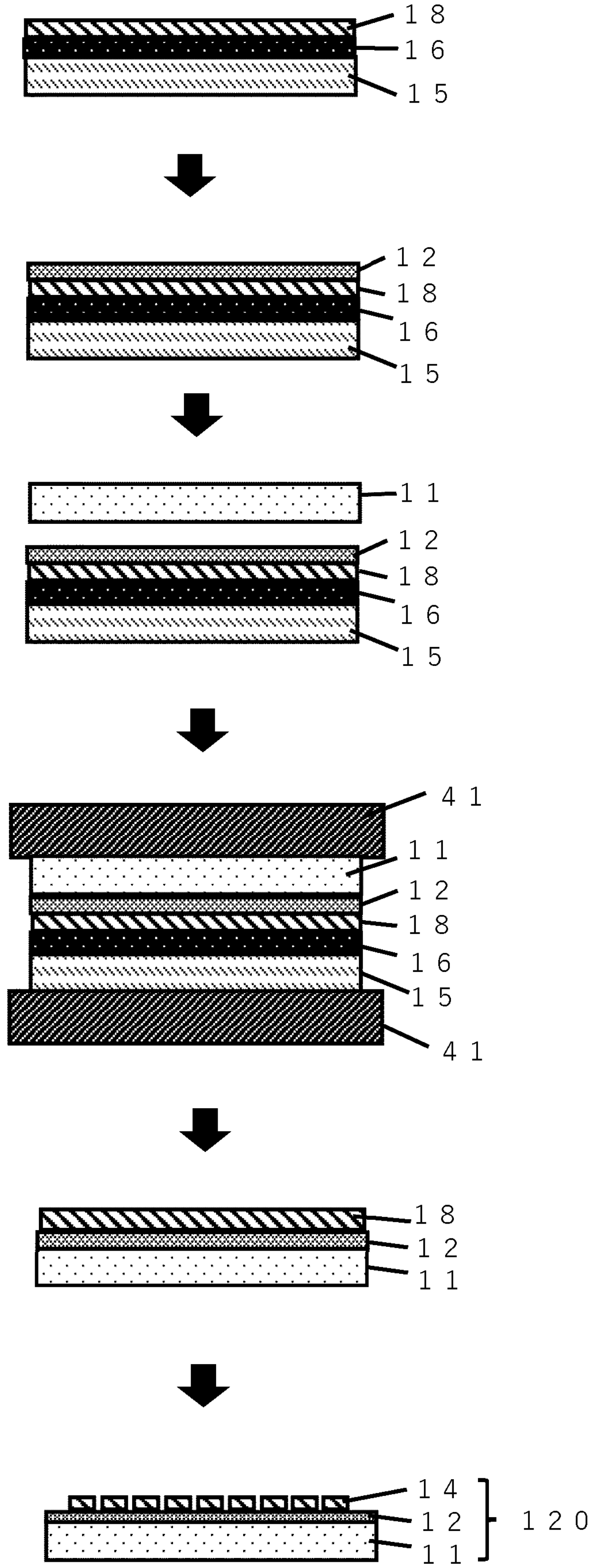
18
16
15
12
18
16
15
11
12
18
16
15
41
11
12
18
16
15
41
18
12
11
14
12
11
120

Figure 5

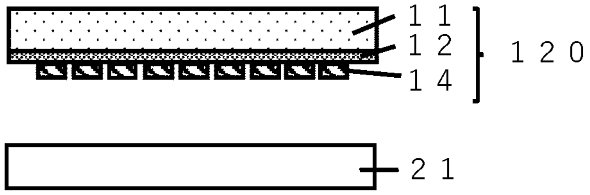


Figure 6

6a

6b

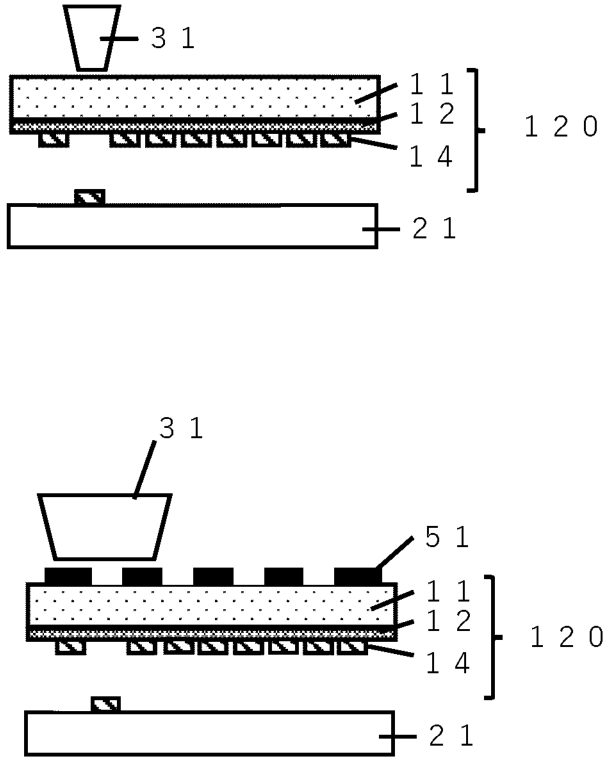

**INTERNATIONAL SEARCH REPORT**

International application No.
**PCT/JP2022/013454**

**A. CLASSIFICATION OF SUBJECT MATTER**

***B32B 27/00***(2006.01)i; ***H01L 23/14***(2006.01)i; ***H01L 21/02***(2006.01)i; ***H01L 21/52***(2006.01)i
FI: H01L21/52 C; B32B27/00 Z; H01L23/14 R; H01L21/02 C

According to International Patent Classification (IPC) or to both national classification and IPC

**B. FIELDS SEARCHED**

Minimum documentation searched (classification system followed by classification symbols)

B32B27/00; H01L23/14; H01L21/02; H01L21/52

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 11-281804 A (TORAY IND INC) 15 October 1999 (1999-10-15) paragraphs [0001], [0011]-[0040] | 14-15<br>1-13, 16-24 |
| X<br>A | JP 2020-188037 A (SAMSUNG ELECTRONICS CO LTD) 19 November 2020 (2020-11-19) paragraphs [0008], [0023]-[0058], fig. 1-9 | 1-4, 8, 12, 22-24<br>5-7, 9-11, 13-21 |
| A | JP 2014-515883 A (NDSU RESEARCH FOUNDATION) 03 July 2014 (2014-07-03) paragraphs [0015], [0048]-[0055], fig. 1 | 1-24 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 June 2022** | **14 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/013454**

| Patent document cited in search report | Publication date (day/month/year) | Patent family member(s) | Publication date (day/month/year) |
|---|---|---|---|
| JP 11-281804 A | 15 October 1999 | (Family: none) | |
| JP 2020-188037 A | 19 November 2020 | US 2020/0357950 A1<br>paragraphs [0005], [0042]-[0077], fig. 1-9<br>KR 10-2020-0130076 A | |
| JP 2014-515883 A | 03 July 2014 | US 2014/0238592 A1<br>paragraphs [0016], [0049]-[0056], fig. 1<br>WO 2012/142177 A2<br>CN 103597589 A<br>KR 10-2014-0045936 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017531915 A
- JP 2020129638 A
- JP 2020188037 A
- JP 2010251359 A
- WO 2014515883 A
- JP 3120476 B